(19) Europäisches Patentamt
European Patent Office
Office européen des brevets

(11) EP 2 530 786 A1

(12) **EUROPEAN PATENT APPLICATION**
published in accordance with Art. 153(4) EPC

(43) Date of publication:
**05.12.2012 Bulletin 2012/49**

(21) Application number: **11736877.9**

(22) Date of filing: **18.01.2011**

(51) Int Cl.:
***H01R 11/01*** *(2006.01)* ***C09D 7/12*** *(2006.01)*
***C09D 201/00*** *(2006.01)* ***H01B 1/22*** *(2006.01)*
***H01B 5/16*** *(2006.01)* ***H01L 21/60*** *(2006.01)*
***H01R 4/02*** *(2006.01)* ***H01R 43/02*** *(2006.01)*
***H05K 3/32*** *(2006.01)*

(86) International application number:
**PCT/JP2011/050684**

(87) International publication number:
**WO 2011/093162 (04.08.2011 Gazette 2011/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.01.2010 JP 2010019737**

(71) Applicant: **Sumitomo Bakelite Company Limited**
**Shinagawa-ku**
**Tokyo 140-0002 (JP)**

(72) Inventors:
- **KAGIMOTO Tomohiro**
  **Tokyo 140-0002 (JP)**
- **CHUMA Toshiaki**
  **Tokyo 140-0002 (JP)**

(74) Representative: **Solf, Alexander**
**Patentanwälte Dr. Solf & Zapf**
**Candidplatz 15**
**81543 München (DE)**

# (54) CONDUCTIVE CONNECTION SHEET, METHOD FOR CONNECTING TERMINALS, METHOD FOR FORMING CONNECTION TERMINAL, SEMICONDUCTOR DEVICE, AND ELECTRONIC DEVICE

(57) A conductive connecting sheet (1) of the present invention is composed of a layered body including resin composition layers (11, 13) and a metal layer (12), and each resin composition layer (11, 13) satisfies the following requirement A: in the case where at least a part of metal ball(s) made of the metal material having low melting point is provided within each resin composition layer (11, 13), the metal ball(s) is heated at a temperature which is a melting temperature thereof or higher according to "test methods for soldering resin type fluxes" defined in JIS Z 3197, and then a wet extension of the metal ball (s) is measured, the wet extension is 37% or more. If the conductive connecting sheet is used for forming connection portions electrically connecting terminals to each other, the connection portions can be formed by selectively aggregating a heated and melted metal material between the terminals and a sealing layer constituted from a resin component can be formed so as to surround the connection portions. As a result, since peripheries of the connection portions can be covered by the resin component, the connection portions are fixed. Further, since an insulating property between the adjacent terminals can be secured by the sealing layer, generation of a leak current between the adjacent terminals can be reliably prevented.

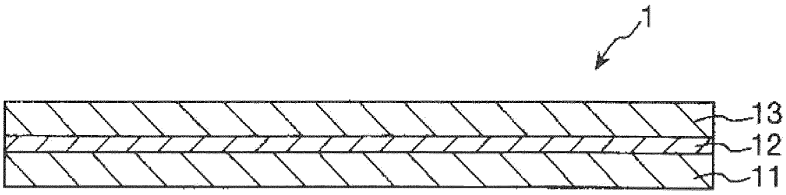


FIG. 2

EP 2 530 786 A1

## Description

### TECHNICAL FIELD

The present invention relates to a conductive connection sheet (conductive connecting sheet), a method for connecting terminals, a method for forming connection terminal, a semiconductor device, and an electronic device.

### RELATED ART

In recent years, in order to meet a demand for developing an electronic device having a high function and a small size, a pitch between connection terminals thereof is being narrowed. It also becomes difficult to connect terminals in a fine pitch circuit.

As a method for connecting the terminals, for example, there is known a flip chip technique in which a plurality of terminals of an IC chip are electrically connected to a circuit board using an anisotropic conductive adhesive or an anisotropic conductive film all at once. Such an anisotropic conductive adhesive or anisotropic conductive film is a paste or film in which conductive particles are dispersed into an adhesive formed of a thermosetting resin as a major component thereof.

Therefore, it is possible to connect a plurality of facing terminals of electronic members to each other all at once through aggregated conductive particles by placing the above anisotropic conductive adhesive or anisotropic conductive film between the electronic members to be bonded, and then being thermally compression bonded, while securing an insulating property between the adjacent terminals due to a resin contained in the adhesive.

However, it is difficult to control aggregation of the conductive particles in the anisotropic conductive adhesive or the anisotropic conductive film. This causes a problem in which a part of the facing terminals cannot be conducted due to insufficient contact between the conductive particles and the terminals or between the conductive particles. Further, this also causes a problem in which the insulating property between the adjacent terminals cannot be sufficiently secured due to the conductive particles contained in a resin existing within an area (that is, an insulating area) other than an area (that is, a conducting area) located between the facing terminals. For these reasons, it is difficult to further narrow the pitch between the terminals by using the technique.

On the other hand, conventionally, formation of the connection terminals on the electronic member is carried out by printing a solder paste onto a substrate on which metal pads are provided, and then heating the solder paste using a solder reflow machine or the like to thereby melt it. However, by using such a method, there is a case that a cost of a mask for printing the solder paste becomes high if the pitches between the connection terminals to be formed are narrow, or a case that the solder paste cannot be printed if the connection terminals to be formed are small.

Further, by using a method for forming the connection terminals in which solder balls are mounted on the substrate, and then the solder balls are heated using the solder reflow machine or the like to thereby melt them, there is a case that a cost for producing the solder balls becomes high if the connection terminals to be formed are small, or a case that it becomes technically difficult to produce solder balls each having a small size.

### PRIOR ART DOCUMENT

### PATENT DOCUMENT

Patent document 1: JP-A S61-276873
Patent document 2: JP-A 2004-260131

### SUMMARY OF THE INVENTION

### PROBLEM TO BE SOLVED BY THE INVENTION

In order to solve such problems, it is proposed to use a conductive connecting sheet which is composed of a layered body including a resin composition layer formed of a resin composition containing a resin component and a compound having flux function, and a metal layer formed of a metal material having low melting point.

In the case where the conductive connecting sheet having such a structure is placed between facing terminals of electronic members, the metal material having low melting point is heated at a temperature which is a melting point thereof or higher, the melted metal material is selectively aggregated between the facing terminals to form connection terminals and the resin component is filled into an area between the connection terminals.

Therefore, it becomes possible to connect the plurality of facing terminals to each other through the selectively aggregated metal material (connection terminals) all at once while securing the insulating property between the adjacent terminals due to the resin component contained in the resin composition.

However, it was revealed that when the metal material is melted and aggregated between the facing terminals, flux activity of the resin composition layer becomes too low so that the melted metal material cannot have a sufficient aggregation force. In this case, if the pitches between the adjacent terminals are narrow, the melted metal material cannot be selectively aggregated between the facing terminals in a desired manner. This causes generation of a leakage current between the adjacent terminals.

Therefore, it is an object of the present invention to provide a conductive connecting sheet which contains a metal material having an excellent aggregation property and can suppress generation of a leakage current between adjacent terminals, a method for connecting terminals using the conductive connecting sheet, a method for forming connection terminal using the conductive connecting sheet, a semiconductor device having high reliability and an electronic device having high reliability.

## MEANS FOR SOLVING PROBLEM

In order to achieve the object, the present invention includes the following features (1) to (19).

(1) A conductive connecting sheet composed of a layered body, the layered body comprising:

at least one resin composition layer formed of a resin composition containing a resin component and a compound having flux function; and
a metal layer formed of a metal material having low melting point,
Wherein the resin composition layer satisfies the following requirement A:

in the case where at least a part of metal ball(s) made of the metal material having low melting point is provided within the resin composition layer, the metal ball(s) is heated at a temperature which is a melting temperature thereof or higher according to "test methods for soldering resin type fluxes" defined in JIS Z 3197, and then a wet extension of the metal ball(s) is measured, the wet extension is 37% or more.

(2) The conductive connecting sheet according to the above feature (1), wherein in the case where a diameter of the metal ball before being heated is defined as "D" [mm] and a height of the metal ball after being heated is defined as "H" [mm], the wet extension "S" [%] is obtained based on the following formula 1:

$$S\ [\%] = (D-H)/D \times 100 \cdots \text{formula 1.}$$

(3) The conductive connecting sheet according to the above feature (1) or (2), wherein the metal ball is formed of a metal alloy containing at least two metals selected from the group consisting of tin (Sn), lead (Pb), silver (Ag), bismuth (Bi), indium (In), zinc (Zn), nickel (Ni), antimony (Sb), iron (Fe), aluminum (Al), gold (Au), germanium (Ge) and copper (Cu), or tin alone.

(4) The conductive connecting sheet according to the above feature (3), wherein the metal ball is formed of a Sn-Pb metal alloy, a Sn-Ag-Cu metal alloy or a Sn-Ag metal alloy as a major component thereof.

(5) The conductive connecting sheet according to the above feature (4), wherein the Sn-Pb metal alloy contains a Sn-37Pb metal alloy and the Sn-Ag-Cu metal alloy contains a Sn-3.0Ag-0.5Cu metal alloy.

(6) The conductive connecting sheet according to any one of the above features (1) to (5), wherein a diameter of the metal ball before being heated is 0.5 mm.

(7) The conductive connecting sheet according to any one of the above features (1) to (6), wherein an acid value of the resin composition is in the range of $3.0\times10^{-5}$ to $1.0\times10^{-2}$ mol/g.

(8) The conductive connecting sheet according to the above feature (7), wherein the acid value is calculated using an oxidation reduction titration method.

(9) The conductive connecting sheet according to any one of the above features (1) to (8), wherein an amount of the compound having flux function contained in the resin composition is in the range of 1 to 50 wt%.

(10) The conductive connecting sheet according to any one of the above features (1) to (9), wherein the compound having flux function contains a compound having at least one of a phenolic hydroxyl group and a carboxyl group.

(11) The conductive connecting sheet according to the above feature (10), wherein the compound having flux function contains a compound represented by the following general formula (1):

$$HOOC\text{-}(CH_2)_n\text{-}COOH \qquad (1)$$

where "n" is an integer number of 1 to 20.

(12) The conductive connecting sheet according to the above feature (10), wherein the compound having flux function contains at least one of a compound represented by the following general formula (2) and a compound represented by the following general formula (3):

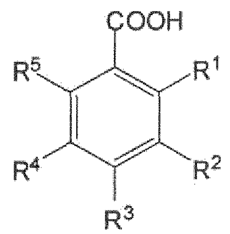

(2)

where each of $R^1$ to $R^5$ is independently an univalent organic group, and at least one of $R^1$ to $R^5$ is a hydroxyl group; and

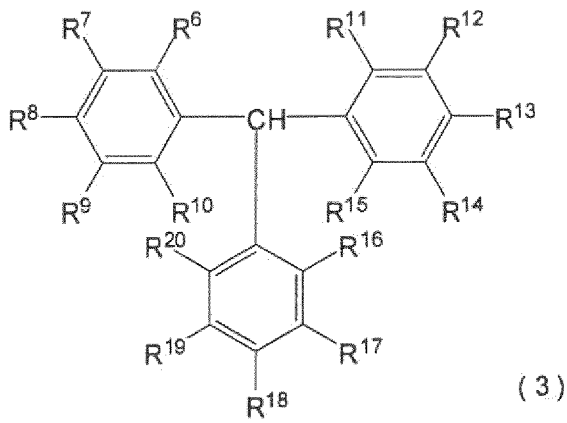

(3)

where each of $R^6$ to $R^{20}$ is independently an univalent organic group, and at least one of $R^6$ to $R^{20}$ is a carboxyl group.

(13) The conductive connecting sheet according to any one of the above features (1) to (12), wherein the at least one resin composition layer comprises two resin composition layers, and
wherein in the layered body, one of the resin composition layers, the metal layer and the other resin composition layer are layered together in this order.

(14) A method for connecting terminals comprising:

a placement step of placing the conductive connecting sheet according to any one of the above features (1) to (13) between facing terminals;
a heat step of heating the conductive connecting sheet at a temperature which is a melting point of the metal material or higher and at which curing of the resin composition is not finished; and
a curing step of curing the resin composition.

(15) A method for connecting terminals comprising:

a placement step of placing the conductive connecting sheet according to any one of the above features (1) to (13) between facing terminals;
a heat step of heating the conductive connecting sheet at a temperature which is a melting point of the metal material or higher and at which the resin composition is softened; and

a hardening step of hardening the resin composition.

(16) A method for forming connection terminal comprising:

a placement step of placing the conductive connecting sheet according to any one of the above features (1) to (13) onto a terminal of an electronic member; and
a heat step of heating the conductive connecting sheet at a temperature which is a melting point of the metal material or higher and at which curing of the resin composition is not finished.

(17) A method for forming connection terminal comprising:

a placement step of placing the conductive connecting sheet according to any one of the above features (1) to (13) onto a terminal of an electronic member; and
a heat step of heating the conductive connecting sheet at a temperature which is a melting point of the metal material or higher and at which the resin composition is softened.

(18) A semiconductor device comprising:

facing terminals; and
a connection portion electrically connecting the facing terminals and being formed using the conductive connecting sheet according to any one of the above features (1) to (13).

(19) An electronic device comprising:

facing terminals; and
a connection portion electrically connecting the facing terminals and being formed using the conductive connecting sheet according to any one of the above features (1) to (13).

## BRIEF DESCRIPTION OF THE DRAWINGS

FIG. 1 is a vertical section view showing one example of a semiconductor device manufactured using a conductive connecting sheet of the present invention.

FIG. 2 is a vertical section view showing an embodiment of the conductive connecting sheet of the present invention.

FIG. 3 is top views each showing another structural example of a metal layer of the conductive connecting sheet of the present invention.

FIG. 4 is a vertical section view explaining a method for forming connection portions and a sealing layer of the semiconductor device using a method for connecting terminals according to the present invention.

FIG. 5 is a vertical section view explaining a method for measuring a wet extension of metal balls according to JIS Z 3197.

FIG. 6 is a vertical section view explaining a method for forming connection terminals so as to correspond to terminals of a semiconductor chip using a method for forming connection terminal according to the present invention.

## MODE FOR CARRING OUT THE INVENTION

Hereinafter, detailed description will be made on a conductive connecting sheet, a method for connecting terminals, a method for forming connection terminal, a semiconductor device and an electronic device according to the present invention based on preferred embodiments described in accompanying drawings.

First, prior to description of the conductive connecting sheet of the present invention, description will be made on a semiconductor device manufactured using the conductive connecting sheet of the present invention.

<Semiconductor device>

FIG. 1 is a vertical section view showing one example of the semiconductor device manufactured using the conductive connecting sheet of the present invention. In the following description, an upper side and a lower side in FIG. 1 will be referred to as "upper" and "lower", respectively.

A semiconductor device 10 shown in FIG. 1 includes a semiconductor chip (semiconductor element) 20, an interposer (substrate) 30 for supporting the semiconductor chip 20, a wiring pattern 40 formed so as to have a predetermined pattern and a plurality of conductive bumps (terminals) 70.

The interposer 30 is an insulating substrate and is formed of, for example, various kinds of resin materials such as a polyimide resin, an epoxy resin, a cyanate resin and a bismaleimide triazine resin (BT resin). A planar shape of this interposer 30 is, generally, a quadrangular shape such as a square shape or a rectangular shape.

The wiring pattern 40 including terminals 41 each formed of, for example, a conductive metal material such as copper is provided on an upper surface (one surface) of the interposer 30 in a predetermined shape.

Further, a plurality of vias (through-holes) not shown in the drawings are formed so as to pass through the interposer 30 in a thickness direction thereof.

One end (upper end) of each of the bumps 70 is electrically connected to a part of the wiring pattern 40 through each of the vias. The other end (lower end) thereof protrudes from a lower surface (the other surface) of the interposer 30.

A portion of each of the bumps 70 protruding from the interposer 30 has a generally spherical shape (ball-like shape).

Each bump 70 is composed of a soldering material such as a solder, a silver solder, a copper solder or a phosphor copper solder as a major component thereof.

Further, the wiring pattern 40 is formed on the interposer 30. Terminals 21 of the semiconductor chip 20 are electrically connected to the wiring pattern 40 through connection portions 81.

Furthermore, a gap between the semiconductor chip 20 and the interposer 30 or the wiring pattern 40 is filled with a sealing agent composed of various kinds of resin materials. A sealing layer 80 is formed from a cured product of the sealing agent. The sealing layer 80 has a function of increasing bonding strength between the semiconductor chip 20 and the interposer 30 or the wiring pattern 40 and a function of preventing foreign materials or moistures from infiltrating into the above gap.

In the semiconductor device 10 having such a structure, the conductive connecting sheet of the present invention is used for forming the connection portions 81 and the sealing layer 80.

Hereinbelow, description will be made on the conductive connecting sheet of the present invention.

<conductive connecting sheet>

FIG. 2 is a vertical section view showing an embodiment of the conductive connecting sheet of the present invention, and FIG. 3 is top views each showing another structural example of a metal layer of the conductive connecting sheet of the present invention. In the following description, an upper side and a lower side in FIG. 2 will be referred to as "upper" and "lower", respectively.

The conductive connecting sheet of the present invention is composed of a layered body including at least one resin composition layer formed of a resin composition containing a resin component and a compound having flux function and a metal layer formed of a metal material having low melting point, and the resin composition layer is characterized by satisfying the following requirement A.

Requirement A: in the case where at least a part of metal ball(s) made of the metal material having low melting point is provided within the resin composition layer, the metal ball is heated at a temperature which is a melting temperature thereof or higher according to "test methods for soldering resin type fluxes" defined in JIS Z 3197, and then a wet extension of the metal ball is measured, the wet extension is 37% or more.

In the case where such a conductive connecting sheet is used for forming connection portions which electrically connect terminals to each other, the connection portions can be formed by selectively aggregating the metal material melted by heat between the terminals and a sealing layer can be formed from the resin component so as to surround the connection portions. As a result, since circumferences of the connection portions are covered by the resin component, the connection portions can be fixed. Further, an insulating property between adjacent terminals is secured by the sealing layer, which makes it possible to reliably prevent generation of a leakage current between the adjacent terminals.

Further, in the case where the conductive connecting sheet is used for forming connection terminals to be provided on corresponding electrodes, the connection terminals can be formed by selectively aggregating the metal material melted by heat onto the electrodes and a reinforcing layer can be formed by the resin component so as to surround the connection terminals. As a result, since circumferences of the connection terminals are covered by the resin component, the connection terminals can be fixed. Further, an insulating property between adjacent connection terminals is secured by the reinforcing layer, which makes it possible to reliably prevent generation of a leakage current

between the adjacent connection terminals.

In this embodiment, as shown in FIG. 2, such a conductive connecting sheet 1 is composed of a layered body having a three layer structure in which a first resin composition layer 11, a metal layer 12 and a second resin composition layer 13 are layered together in this order.

In the conductive connecting sheet 1 having such a structure, each of the first resin composition layer 11 and the second resin composition layer 13 is a layer formed of the resin composition containing the resin component and the compound having flux function, and the metal layer 12 is a layer constituted from a metal foil formed of the metal material having low melting point.

Hereinbelow, description will be made on each of the layers constituting the conductive connecting sheet 1. In this regard, since both the first resin composition layer 11 and the second resin composition layer 13 are formed of the resin composition containing the resin component and the compound having flux function, the first resin composition layer 11 will be representatively described. Further, hereinbelow, the first resin composition layer 11 and the second resin composition layer 13 will be simply referred to as "resin composition layer 11" and "resin composition layer 13", respectively, on occasion.

<<Resin composition layer 11>>

The resin composition layer 11 is formed of the resin composition containing the resin component and the compound having flux function.

In the present invention, as the resin composition, a liquid composition at room temperature or a solid composition at room temperature may be used. Further, in this specification, "liquid state at room temperature" means a state having no constant form at room temperature (25°C), and also includes a paste state.

The resin composition only has to contain the resin component and the compound having flux function. Therefore, it is not limited to a specific type, but may be a curable resin composition or a thermoplastic resin composition.

Examples of the curable resin composition include a curable resin composition capable of being cured by heat, a curable resin composition capable of being cured by irradiation of a chemical ray, and the like. Among them, it is preferable to use the curable resin composition capable of being cured by heat. The curable resin composition capable of being cured by heat has excellent mechanical properties such as a coefficient of thermal expansion and an elastic modulus after being cured.

Further, the thermoplastic resin composition only has to exhibit plasticity at a degree capable of being formed (molded) by being heated at a predetermined temperature. Therefore, it is not limited to a specific type.

(a) Curable resin composition

The curable resin composition contains a curable resin component and the compound having flux function, and is melted by being heated and then cure.

Further, the curable resin composition may contain a film-forming resin, a curing agent, an accelerator, a silane coupling agent and the like, if needed, in addition to the curable resin component and the compound having flux function.

Hereinbelow, detailed description will be made on various kinds of materials contained in the curable resin composition.

(i) Curable resin component

The curable resin component only has to be melted by being heated and then cure. Therefore, it is not limited to a specific type. As the curable resin component, generally, it is preferable to use a resin component capable of being used as an adhesive component for manufacturing a semiconductor device.

Examples of the curable resin component include, but are not particularly limited to, an epoxy resin, a phenoxy resin, a silicone resin, an oxetane resin, a phenol resin, a (meth)acrylic resin, a polyester resin (unsaturated polyester resin), a diallyl phthalate resin, a maleimide resin, a polyimide resin (polyimide precursor resin), a bismaleimide-triazine resin, and the like. It is especially preferred that used is a curable resin component containing at least one kind selected from the group consisting of the epoxy resin, the (meth)acrylic resin, the phenoxy resin, the polyester resin, the polyimide resin, the silicone resin, the maleimide resin and the bismaleimide-triazine resin.

Among them, specifically, it is preferable to use the epoxy resin. This is because the epoxy resin is superior in curability and storage stability and the cured product thereof is excellent in heat resistance, moisture resistance and chemical resistance. In this regard, one of these curable resin components may be used alone or two or more thereof may be used in a combination.

The epoxy resin is not limited to a specific type, but may be a liquid state epoxy resin at room temperature or a solid epoxy resin at room temperature. Further, as the epoxy resin, the liquid epoxy resin at room temperature and

the solid epoxy resin at room temperature may be used in a combination.
In the case of the liquid curable resin composition, it is preferred that the liquid epoxy resin at room temperature is used. On the other hand, in the case of the solid curable resin composition, both the liquid epoxy resin at room temperature and the solid epoxy resin at room temperature can be used. Further, in this case, it is preferred that the curable resin composition contains the film-forming resin component.

Examples of the liquid epoxy resin at room temperature (25°C), but are not particularly limited to, a bisphenol A type epoxy resin, a bisphenol F type epoxy resin and the like. One selected from these liquid epoxy resins or a combination of two or more selected therefrom can be used.

An epoxy equivalent of the liquid epoxy resin at room temperature is preferably in the range of 150 to 300 g/eq, more preferably in the range of 160 to 250 g/eq, and even more preferably in the range of 170 to 220 g/eq. If the epoxy equivalent is less than the above lower limit value, a contraction percentage of the cured product tends to increase depending on the kind of the epoxy resin to be used. This causes a fear that a warp occurs in the semiconductor device 10 or an electronic device in which the semiconductor device 10 is used. On the other hand, if the epoxy equivalent exceeds the above upper limit value, in the case where the curable resin composition contains the film-forming resin component, reactivity of the epoxy resin with the film-forming resin component, especially, the polyimide resin tends to decrease.

Examples of the solid epoxy resin at room temperature include, but are not particularly limited to, a bisphenol A type epoxy resin, a bisphenol S type epoxy resin, a phenol novolak type epoxy resin, a cresol novolak type epoxy resin, a glycidyl amine type epoxy resin, a glycidyl ester type epoxy resin, a three functional epoxy resin, a four functional epoxy resin and the like. One selected from these solid epoxy resins or a combination of two or more selected therefrom can be used. Among them, it is preferable to use the solid three functional epoxy resin, the cresol novolak type epoxy resin or the like.

In this regard, an epoxy equivalent of the solid epoxy resin at room temperature is preferably in the range of 150 to 3,000 g/eq, more preferably in the range of 160 to 2,500 g/eq, and even more preferably in the range of 170 to 2,000 g/eq.

A softening point of the solid epoxy resin at room temperature is preferably in the range of about 40 to 120°C, more preferably in the range of about 50 to 110°C, and even more preferably in the range of about 60 to 100°C. If the softening point falls within the above range, it is possible to suppress tackiness of the curable resin composition so that it can be easily handled.

Further, an amount of the above mentioned curable resin component contained in the curable resin composition can be set to an appropriate value depending on the type of the curable resin composition to be used.

For example, in the case of the liquid curable resin composition, the amount of the curable resin component contained therein is preferably 10 wt% or more, more preferably 15 wt% or more, even more preferably 20 wt% or more, moreover preferably 25 wt% or more, and especially preferably 30 wt% or more. Further, the amount is preferably less than 100 wt%, more preferably 95 wt% or less, even more preferably 90 wt% or less, moreover preferably 75 wet% or less, moreover preferably 65 wt% or less, and especially preferably 55 wt% or less.

Further, in the case of the solid curable resin composition, the amount of the curable resin component contained therein is preferably 5 wt% or more, more preferably 10 wt% or more, even more preferably 15 wt% or more, and especially preferably 20 wt% or more. Further, the amount is preferably 90 wt% or less, more preferably 85 wt% or less, even more preferably 80 wet% or less, moreover preferably 75 wt% or less, moreover preferably 65 wt% or less, and especially preferably 55 wt% or less.

If the amount of the curable resin component contained in the curable resin composition is set to a value falling within the above range, it is possible to sufficiently secure electrical connecting strength and mechanical bonding strength between the terminals. 21 and 41.

(ii) Film-forming resin component

In the case where as the curable resin composition, the solid composition is used as described above, it is preferred that the curable resin composition further contains the film-forming resin component in addition to the curable resin component.

As such a film-forming resin component, any components can be used as long as they are capable of being dissolved into an organic solvent and have a film-forming property in themselves. Therefore, the film-forming resin component is not limited to a specific kind. A thermoplastic resin or a thermosetting resin can be used or a combination thereof also can be used.

Specifically, examples of the film-forming resin component include, but are not particularly limited to, a (meth) acryl-based resin, a phenoxy resin, a polyester resin, a polyurethane resin, a polyimide resin, a polyamide imide resin, a cyclohexane-modified polyimide resin, a polybutadiene resin, a polypropylene resin, a styrene-butadiene-styrene copolymer, a styrene-ethylene-butylene-styrene copolymer, a polyacetal resin, a polyvinyl butyral resin, a polyvinyl acetal

resin, butyl rubber, chloroprene rubber, a polyamide resin, an acrylonitrile-butadiene copolymer, an acrylonitrile-butadiene-acrylic acid copolymer, an acrylonitrile-butadiene-styrene copolymer, polyvinyl acetate, nylon, and the like. One selected from these film-forming resin components or a combination of two or more selected therefrom can be used. Among them, preferable is the (meth)acryl-based resin, the phenoxy resin, the polyester resin, the polyimide resin or the polyimide resin.

The term " (meth) acryl-based resin" used in this specification refers to a polymer of a (meth)acrylic acid or derivatives thereof, or a copolymer of the (meth)acrylic acid or derivative thereof and other monomers. In this regard, the expression "(meth)acryl-based acid" or the like used herein denotes "acrylic acid or methacrylic acid" or the like.

Examples of the (meth)acryl-based resin include, but are not particularly limited to, polyacrylic acid, polymethacrylic acid, polyacrylic esters such as polymethyl acrylate, polyethyl acrylate, polybutyl acrylate and poly-2-ethyl hexyl acrylate, polymethacrylates such as polymethyl methacrylate, polyethyl methacrylate and polybutyl methacrylate, polyacrylonitrile, polymethacrylonitrile, polyacrylamide, a butyl acrylate-ethyl acrylate-acrylonitrile copolymer, an acrylonitrile-butadiene copolymer, an acrylonitrile-butadiene-acrylic acid copolymer, an acrylonitrile-butadiene-styrene copolymer, an acrylonitrile-styrene copolymer, a methyl methacrylate-styrene copolymer, a methyl methacrylate-acrylonitrile copolymer, a methyl methacrylate-α-methyl styrene copolymer, a butyl acrylate-ethyl acrylate-acrylonitrile-2-hydroxyethyl methacrylate-methacrylic acid copolymer, a butyl acrylate-ethyl acrylate-acrylonitrile-2-hydroxyethyl methacrylate-acrylic acid copolymer, a butyl acrylate-acrylonitrile-2-hydroxyethyl methacrylate copolymer, a butyl acrylate-acrylonitrile-acrylic acid copolymer, a butyl acrylate-ethyl acrylate-acrylonitrile copolymer, an ethyl acrylate-acrylonitrile-N,N-dimethyl acrylamide copolymer, and the like. One selected from these (meth)acryl-based resins or a combination of two or more selected therefrom can be used. Among them, preferable is the butyl acrylate-ethyl acrylate-acrylonitrile copolymer or the ethyl acrylate-acrylonitrile-N,N-dimethyl acrylamide copolymer.

Further, examples of a main chemical structure (skeleton) of the phenoxy resin include, but are not particularly limited to, a bisphenol A type, a bisphenol F type, a biphenyl type and the like.

Furthermore, the polyimide resin is not limited to a specific kind as long as it is a resin having repeating units each including an imide bond. Examples of such a polyimide resin include a polymer obtained by reacting diamine with acid dianhydride to synthesize polyamide acid, and then heating the polyamide acid to dehydrate and ring-close it.

Examples of the diamine include, but are not particularly limited to, aromatic diamines such as 3,3'-dimethyl-4,4'-diamino diphenyl, 4,6-dimethyl-m-phenylenediamine, 2,5-dimethyl-p-phenylenediamine; siloxanediamines such as 1,3-bis(3-aminopropyl)-1,1,3,3-tetramethyl disiloxane, and the like. One selected from these diamines or a combination of two or more selected therefrom can be used.

Moreover, examples of the acid dianhydride include 3,3,4,4'-biphenyl tetracarboxylic acid, pyromellitic acid dianhydrate, 4,4'-oxydiphthalic acid dianhydrate, and the like. One selected from these acid dianhydrides or a combination of two or more selected therefrom can be used.

The polyimide resin may be either soluble or insoluble to a solvent, but is preferably a resin soluble to a solvent. This is because such a resin can be easily mixed with the other components (e.g., the curable resin component) thereby preparing a varnish, and to be appropriately handled. In particular, it is preferable to use the siloxane-modified polyimide resin which can be dissolved into various kinds of solvents.

A weight average molecular weight of the film-forming resin component is not limited to a specific value, but is preferably in the range of about 8,000 to 1,000,000, more preferably in the range of about 8,500 to 950,000, and even more preferably in the range of about 9,000 to 900,000. If the weight average molecular weight of the film-forming resin component falls within the above range, it is possible to improve a film-forming property of the curable resin composition and to suppress flowability of the resin composition layer 11 before being cured.

In this regard, the weight average molecular weight of the film-forming resin component can be measured using, for example, a gel permeation chromatography (GPC).

Further, the film-forming resin component may be a commercially available component. A film-forming resin component containing various kinds of additives such as a plasticizer, a stabilizing agent, an inorganic filler, an antistatic agent and a pigment to an extent that does not mar effects provided by the present invention also may be used.

Further, an amount of the above mentioned film-forming resin component contained in the curable resin composition can be set to an appropriate value depending on the type of the curable resin composition to be used.

For example, in the case of the solid curable resin composition, the amount of the film-forming resin component contained therein is preferably 5 wt% or more, more preferable 10 wt% or more, and even more preferably 15 wt% or more. Further, the amount is preferably 50 wt% or less, more preferably 45 wt% or less, and even more preferably 40 wt% or less. If the amount of the film-forming resin component contained in the curable resin composition falls within the above range, it is possible to suppress the flowability of the curable resin composition before being melted, to thereby easily handle the resin composition layer (conductive connection material) 11.

(iii) Compound having flux function

The compound having flux function has a function of reducing oxide layers formed on surfaces of the terminals 21 and 41 and the metal layer 12.

Such a compound having flux function is not limited to a specific kind. As the compound having flux function, it is preferable to use a compound having phenolic hydroxyl group and/or carboxyl group.

Examples of the compound having phenolic hydroxyl group include: a monomer having phenolic hydroxyl group such as phenol, o-cresol, 2,6-xylenol, p-cresol, m-cresol, o-ethyl phenol, 2,4-xylenol, 2,5-xylenol, m-ethyl phenol, 2,3-xylenol, mesitol, 3,5-xylenol, p-tert-butyl phenol, catechol, p-tert-amyl phenol, resorcinol, p-octyl phenol, p-phenyl phenol, bisphenol F, bisphenol AF, biphenol, diallyl bisphenol F, diallyl bisphenol A, trisphenol or tetrakisphenol; a resin having phenolic hydroxyl group such as a phenol novolak resin, an o-cresol novolak resin, a bisphenol F novolak resin or a bisphenol A novolak resin, and the like. One selected from these compounds or a combination of two or more selected therefrom can be used.

Further, examples of the compound having carboxyl group include an aliphatic acid anhydride, an alicyclic acid anhydride, an aromatic acid anhydride, an aliphatic carboxylic acid, an aromatic carboxylic acid, and the like. Examples of the aliphatic acid anhydride include succinic acid anhydride, polyadipic acid anhydride, polyazelaic acid anhydride, polysebacic acid anhydrate, and the like.
Examples of the alicyclic acid anhydride include methyl tetrahydrophthalic acid anhydride, methyl hexahydrophthalic acid anhydride, methyl himic acid anhydride, hexahydrophthalic acid anhydride, tetrahydrophthalic acid anhydride, trialkyl tetrahydrophthalic acid anhydride, methyl cyclohexene dicarboxylic acid anhydride, and the like. Examples of the aromatic acid anhydride include phthalic acid anhydride, trimellitic acid anhydride, pyromellitic acid dianhydride, benzophenone tetracarboxylic acid anhydrate, ethylene glycol bistrimellitate, glycerol tristrimellitate, and the like. One selected from these compounds or a combination of two or more selected therefrom can be used.

Examples of the aliphatic carboxylic acid include, formic acid, acetic acid, propionic acid, butyric acid, valeric acid, pivalic acid, caproic acid, caprylic acid, lauric acid, myristic acid, palmitic acid, stearic acid, acrylic acid, methacrylic acid, crotonic acid, oleic acid, fumaric acid, maleic acid, oxalic acid, malonic acid, succinic acid, glutaric acid, adipic acid, sebacic acid, dodecane dionic acid, pimelic acid, and the like. One selected from these carboxylic acids or a combination of two or more selected therefrom can be used. Among them, it is preferable to use a compound represented by the following general formula (1)

$$HOOC\text{-}(CH_2)_n\text{-}COOH \qquad (1)$$

where in the above formula (1), "n" is an integer number of 0 to 20.
Further, it is more preferable to use the adipic acid, the sebacic acid or the dodecane dionic acid.

The aromatic carboxylic acid is not limited to a specific kind, but is preferably a compound represented by the following formula (2) or the following formula (3).

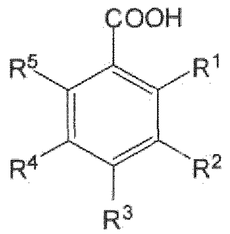

(2)

In the formula (2), each of $R^1$ to $R^5$ is independently an univalent organic group, and at least one of $R^1$ to $R^5$ is a hydroxyl group.

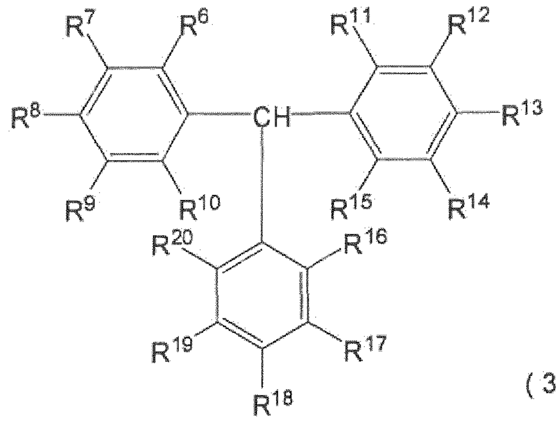

(3)

In the formula (3), each of $R^6$ to $R^{20}$ is independently an univalent organic group, and at least one of $R^6$ to $R^{20}$ is a carboxyl group.
Examples of such an aromatic carboxylic acid include: benzoic acid; phthalic acid; isophthalic acid; terephthalic acid; hemimellitic acid; trimellitic acid; trimesic acid; mellophanic acid; platonic acid; pyromellitic acid; mellitic acid; xylic acid; hemelitic acid; mesitylenic acid; prehnitylic acid; toluic acid; cinnamic acid; benzoic acid derivatives such as salicylic acid, 2,3-dihydroxybenzoic acid, 2,4-dihydroxybenzoic acid, gentisic acid (2,5-dihydroxybenzoic acid), 2,6-dihydroxybenzoic acid, 3,5-dihydroxybenzoic acid and gallic acid (3,4,5-trihydroxybenzoic acid); naphthoic acid derivatives such as 1 ,4-dihydroxy-2-naphthoic acid and 3,5-dihydroxy-2-naphthoic acid; phenol phthalin; diphenolic acid; and the like. One selected from these aromatic carboxylic acids or a combination of two or more selected therefrom can be used.

Such a compound having flux function has the function of reducing the oxide layers on the surfaces of the metal layer 12 and the terminals 21 and 41 so that the metal layer 12 and the terminals 21 and 41 are electrically connected to each other. Further, the compound having flux function preferably has a functional group capable of reacting with the curable resin component so as to serve as a curing agent for curing the curable resin component.

Such a functional group is appropriately selected based on the kind of the curable resin component. For example, in the case where the curable resin component is the epoxy resin, examples of the functional group include a functional group capable of reacting with the epoxy group such as a carboxyl group, a hydroxyl group or an amino group. When the curable resin composition is melted, such a compound having flux function can improve wettability of the surfaces of the metal layer 12 and the terminals 21 and 41 by reducing the oxide layers formed thereon, so that the connection portions 81 are easily produced to thereby electrically connect the terminals 21 and 41 to each other.
Further, after the terminals 21 and 41 have been connected to each other through the connection portions 81, this compound serves as the curing agent so as to exhibit a function of increasing an elastic modulus or Tg of the curable resin component by being bonding thereto. Thus, by using the compound having flux function as a flux, it is possible to omit an operation of cleaning a flux and to effectively suppress or prevent occurrence of migration which would be caused due to residue of the flux.

Examples of the compound having flux function which exhibits such an action include a compound having at least one carboxyl group. For example, in the case where the curable resin component is the epoxy resin, examples of the compound having flux function include aliphatic dicarboxylic acid, a compound having carboxyl and phenolic hydroxyl groups, and the like.

Examples of the aliphatic dicarboxylic acid include, but are not particularly limited to, a compound in which two carboxyl groups are bonded to an aliphatic hydrocarbon group. The aliphatic hydrocarbon group may be a saturated or unsaturated acyclic type or may be a saturated or unsaturated cyclic type. Further, in the case where the aliphatic hydrocarbon group is the acyclic type, it may be a linear type or a branched type.

Examples of such an aliphatic dicarboxylic acid include a compound represented by the above formula (1) in which "n" is an integer number of 1 to 20. If "n" shown in the above formula (1) falls within the above range, the aliphatic dicarboxylic acid can have an excellent flux activity, generation of outgases can be effectively prevented during bonding, the cured product of the curable resin composition can have an superior elastic modulus and an appropriate glass transition temperature in a high balance.
In particular, in order to improve a bonding property of the cured product of the curable resin composition with respect to an object to be bonded such as an interposer 30 by preventing the elastic modulus thereof from increasing, it is preferred that "n" is 3 or more. Further, in order to further improve connection reliability by suppressing the elastic modulus of the cured product of the curable resin composition from decreasing, it is preferred that "n" is 10 or less.

Further, examples of the aliphatic dicarboxylic acid represented by the above formula (1) include glutaric acid, adipic acid, pimelic acid, suberic acid, azelaic acid, sebacic acid, undecane diacid, dodecane diacid, tridecane diacid,

tetradecane diacid, pentadecane diacid, octadecane diacid, nonadecane diacid, eicosane diacid, and the like. Among them, the adipic acid, the suberic acid, the sebacic acid or the dodecane diacid is preferable, and the sebacic acid is more preferable.

Furthermore, examples of the compound having carboxyl and phenolic hydroxyl groups include: benzoic acid derivatives such as salicylic acid, 2,3-dihydroxybenzoic acid, 2,4-dihydroxybenzoic acid, gentisic acid (2,5-dihydroxybenzoic acid), 2,6-dihydroxybenzoic acid, 3,4-dihydroxybenzoic acid and gallic acid (3,4,5-trihydroxybenzoic acid); naphthoic acid derivatives such as 1,4-dihydroxy-2-naphthoic acid and 3,5-dihydroxy-2-naphthoic acid; phenol phthalin; diphenolic acid; and the like. Among them, the phenol phthalin, the gallic acid, the 2,4-dihydroxybenzoic acid or the 2,6-dihydroxybenzoic acid is preferable, and the phenol phthalin or the gallic acid is more preferable.

One selected from the above mentioned compounds having flux function or a combination of two or more selected therefrom can be used.

In this regard, since all the compounds easily absorb moisture, which would cause generation of voids, it is preferred that they can be, in advance, dried before being used in the present invention.

An amount of the compound having flux function contained in the curable resin composition can be set to an appropriate value depending on the type of the curable resin composition to be used.

For example, in the case of the liquid curable resin composition, the amount of the compound having flux function contained therein is preferable 1 wt% or more, more preferably 2 wt% or more, and even more preferably 3 wt% or more with regard to a total amount of the curable resin composition. Further, the amount is preferably 50 wt% or less, more preferably 40 wt% or less, even more preferably 30 wt% or less, and especially preferably 25 wt% or less with regard to the total amount of the curable resin composition.

Further, in the case of the solid curable resin composition, the amount of the compound having flux function contained therein is preferably 1 wt% or more, more preferably 2 wt% or more, and even more preferably 3 wt% or more with regard to the total amount of the curable resin composition. Further, the amount is preferably 50 wt% or less, more preferably 40 wt% or less, even more preferably 30 wt% or less, and especially preferably 25 wt% or less with regard to the total amount of the curable resin composition.

If the amount of the compound having flux function falls within the above range, it is possible to reliably remove the oxide layers on the surfaces of the metal layer 12 and the terminals 21 and 41 so that they are electrically connected to each other. Further, it is possible to effectively bond the compound having flux function to the curable resin component when the curable resin composition is cured, to thereby improve the elastic modulus or the Tg of the curable resin composition. Furthermore, it is possible to suppress occurrence of ion migration due to the compound having flux function not reacted.

(iv) Curing agent

Examples of a curing agent other than the compound having flux function include, but are not particularly limited to, phenols, amines, thiols and the like. Such a curing agent can be appropriately selected depending on the kind or the like of the curable resin component. For example, in the case where the epoxy resin is used as the curable resin component, it is preferable to use the phenols from the viewpoint that the phenols have appropriate reactivity with the epoxy resin, the curable resin composition is difficult to be varied in a size during the curing and can have suitable physical properties (e.g., thermal resistance and moisture resistance) after the curing, and more preferable to use phenols each having two or more functional groups from the viewpoint that the curable resin component can exhibit excellent physical properties after the curing. In this regard, one selected from these curing agents or a combination of two or more selected therefrom can be used.

Examples of the phenols include bisphenol A, tetramethyl bisphenol A, diallyl bisphenol A, biphenol, bisphenol F, diallyl bisphenol F, trisphenol, tetrakisphenol, a phenol novolak resin, a cresol novolak resin, and the like. One selected from these phenols or a combination of two or more selected therefrom can be used. Among them, the phenol novolak resin or the cresol novolak resin is preferable from the viewpoint that it has a good melt viscosity, an appropriate reactivity with the epoxy resin, and superior physical properties after the curing.

Further, an amount of the above mentioned curing agent contained in the curable resin composition can be set to an appropriate value depending on the kind of the curable resin component or curing agent to be used, or the kind or number of a functional group capable of serving as a curing agent which may be contained in the compound having flux function.

For example, in the case where the epoxy resin is used as the curable resin component, the amount of the curing agent contained in the curable resin composition is preferably in the range of about 0.1 to 50 wt%, more preferably in the range of about 0.2 to 40 wt%, and even more preferably in the range of about 0.5 to 30 wt% with regard to a total amount of the curable resin composition. If the amount of the curing agent falls within the above range, it is possible to sufficiently secure the electrical connecting strength and the mechanical bonding strength of the connection portions 81 formed between the terminals 21 and 41.

(v) Accelerator

The curable resin composition may further contain an accelerator in addition to the above mentioned various kinds of components. This makes it possible to reliably and easily cure the curable resin composition.
Examples of the accelerator include, but are not particularly limited to, imidazole compounds such as an isocyanuric acid adduct of imidazole, 2-methyl imidazole, 2-undecyl imidazole, 2-heptadecyl imidazole, 1,2-dimethyl imidazole, 2-ethyl-4-methyl imidazole, 2-phenyl imidazole, 2-phenyl-4-methyl imidazole, 1-benzyl-2-phenyl imidazole, 1-benzyl-2-methyl imidazole, 1-cyanoethyl-2-methyl imidazole, 1-cyanoethyl-2-ethyl-4-methyl imidazole, 1-cyanoethyl-2-undecyl imidazole, 1-cyanoethyl-2-phenyl imidazole, 1-cyanoethyl-2-undecyl imidazolium trimellitate, 1-cyanoethyl-2-phenyl imidazolium trimellitate, 2,4-diamino-6-[2'-methyl imidazolyl(1')]-ethyl-s-triazine, 2,4-diamino-6-[2'-undecyl imidazolyl(1')]-ethyl-s-triazine, 2,4,-diamino-6-[2'-ethyl -4-methyl imidazolyl(1')]-ethyl-s-triazine or 2,4-diamino-6-[2'-methyl imidazolyl(1')]-ethyls-triazine, an isocyanuric acid adduct of 2-phenyl imidazole, an isocyanuric acid adduct of 2-methyl imidazole, and 2-phenyl-4,5-dihydroxy dimethyl imidazole or 2-phenol-4-methyl-5-hydroxy methyl imidazole. One selected from these imidazole compounds or a combination of two or more selected therefrom can be used.
Further, an amount of the above mentioned accelerator contained in the curable resin composition can be set to an appropriate value depending on the kind of the accelerator to be used.
For example, in the case where the imidazole compound is used, the amount of the imidazole compound contained in the curable resin composition is preferably 0.001 wt% or more, more preferably 0.003 wt% or more, and even more preferably 0.005 wt% or more. Further, the amount is preferably 1.0 wt% or less, more preferably 0.7 wt% or less, and even more preferably 0.5 wt% or less.
If the amount of the imidazole compound is less than the above lower limit value, there is a case that an action of the accelerator cannot be sufficiently exhibited depending on the kind of the accelerator to be used, which makes it impossible to sufficiently cure the curable resin composition. On the other hand, if the amount of the imidazole compound exceeds the above upper limit value, there is a fear that the melted metal layer 12 does not sufficiently move on the surfaces of the terminals 21 and 41 before the curing of the curable resin composition is finished so that a part of the metal layer 12 exists within the sealing layer 80 to be formed in the insulating area, which makes it impossible to sufficiently secure the insulating property of the sealing layer 80.

(vi) Silane coupling agent

Further, the curable resin composition can further contain a silane coupling agent.
Examples of the silane coupling agent include, but are not particularly limited to, an epoxy silane coupling agent, an aromatic series containing amino silane coupling agent and the like. By using such a silane coupling agent, it is possible to improve adhesiveness of the curable resin composition with respect to a member to be bonded (adherend) such as the interposer 30.
In this regard, one selected from such silane coupling agents or a combination of two or more selected therefrom can be used.
Further, an amount of the above mentioned silane coupling agent contained in the curable resin composition can be set to an appropriate value depending on the kind of the member to be bonded, the curable resin component or the like. For example, the amount of the silane coupling agent contained in the curable resin composition is preferably 0.01 wt% or more, more preferably 0.05 wt% or more, and even and more preferably 0.1 wt% or more. Further, the amount is preferably 2 wt% or less, more preferably 1.5 wt% or less, and even more preferably 1 wt% or less.
In this regard, the curable resin composition may further contain additives such as a plasticizer, a stabilizing agent, a tackifier, a lubricant, an oxidation inhibitor, an inorganic filler, an antistatic agent, a pigment and the like in addition to the above mentioned components.
Further, the above mentioned curable resin composition can be prepared by mixing/dispersing each of the above components. A method for mixing or dispersing each component is not particularly limited to a specific method. The above components can be mixed or dispersed using a well-known conventional method.
Furthermore, the liquid curable resin composition may be prepared by mixing each component with or without using a solvent. The solvent is not limited to a specific kind as long as it is inert with regard to the above components. Examples of the solvent include: ketones such as acetone, methyl ethyl ketone (MEK), methyl isobutyl ketone (MIBK), diisobutyl ketone (DIBK), cyclohexanone and diacetone alcohol (DAA); aromatic hydrocarbons such as benzene, xylene and toluene; alcohols such as methyl alcohol, ethyl alcohol, isopropyl alcohol and n-butyl alcohol; cellosolves such as methyl cellosolve, ethyl cellosolve, butyl cellosolve, methyl cellosolve acetate and ethyl cellosolve acetate; N-methyl-2-pyrolidone (NMP); tetrahydrofuran (THF); dimethyl formamide (DMF); dibase acid ester (DBE); 3-methoxy ethyl propionate (EEP); dimethyl carbonate (DMC); and the like. One selected from these solvents or a combination of two or more selected therefrom can be used. Further, the solvent is preferably used so that a solid content concentration of the components mixed with the solvent becomes 10 to 60 wt%.

(b) Thermoplastic resin composition

The thermoplastic resin composition contains a thermoplastic resin component and the compound having flux function, and is softened at a predetermined temperature.

Further, the thermoplastic resin composition may contain a film-forming resin, a silane coupling agent and the like, if needed, in addition to the thermoplastic resin component and the compound having flux function.

(i) Thermoplastic resin composition

Examples of the thermoplastic resin composition include, but are not particularly limited to, a vinyl acetate-based resin, a polyvinyl alcohol resin, a polyvinyl butyral resin, a vinyl chloride resin, a (meth) acrylic resin, a phenoxy resin, a polyester resin, a polyimide resin, a polyamide imide resin, a siloxane-modified polyimide resin, a polybutadiene resin, an acrylic resin, a styrene resin, a polyethylene resin, a polypropylene resin, a polyamide resin, a cellulose resin, an isobutylene resin, a vinyl ether resin, a liquid crystal polymer resin, a polyphenylene sulfide resin, a polyphenylene ether resin, a polyether sulfone resin, a polyether imide resin, a polyether ether ketone resin, a polyurethane resin, a styrene-butadiene-styrene copolymer, a styrene-ethylenebutylene-styrene copolymer, a polyacetal resin, a polyvinyl acetal resin, butyl rubber, chloroprene rubber, an acrylonitrile-butadiene copolymer, an acrylonitrile-butadiene-acrylic acid copolymer, an acrylonitrile-butadiene-styrene copolymer, polyvinyl acetate, and the like. The thermoplastic resin composition may be used as a homopolymer of the above resin or a copolymer of two or more of the above resins.

A softening point of the thermoplastic resin component is not limited to a specific value, but is preferably 10°C or more lower than a melting point of the metal layer 12 of the conductive connecting sheet 1, more preferably 20°C or more lower than the above melting point, and even more preferably 30°C or more lower than the above melting point.

Further, a decomposition temperature of the thermoplastic resin component is not limited to a specific value, but is preferably 10°C or more higher than the melting point of the metal layer 12, more preferably 20°C or more higher than the above melting point, and even more preferably 30°C or more higher than the above melting point.

Furthermore, an amount of the above mentioned thermoplastic resin component contained in the thermoplastic resin composition can be set to an appropriate value depending on the type of the thermoplastic resin composition to be used.

For example, in the case of the liquid thermoplastic resin composition, the amount of the thermoplastic resin component contained therein is preferably 10 wt% or more, more preferably 15 wt% or more, even more preferably 20 wt% or more, further more preferably 25 wt% or more, moreover preferably 30 wt% or more, and especially preferably 35 wt% or more. Further, the amount is preferably 100 wt% or less, more preferably 95 wt% or less, even more preferably 90 wt% or less, moreover preferably 75 wt% or less, moreover preferably 65 wt% or less, and especially preferably 55 wt% or less.

Further, in the case of the solid thermoplastic resin composition, the amount of the thermoplastic resin component contained therein is preferably 5 wt% or more, more preferably 10 wt% or more, even more preferably 15 wt% or more, and especially preferably 20 wt% or more. Further, the amount is preferably 90 wt% or less, more preferably 85 wt% or less, even more preferably 80 wt% or less, moreover preferably 75 wt% or less, moreover preferably 65 wt% or less, and especially preferably 55 wt% or less.

If the amount of the curable resin component contained in the thermoplastic resin composition is set to a value falling within the above range, it is possible to sufficiently secure electrical connecting strength and mechanical bonding strength between the terminals 21 and 41.

(ii) Compound having flux function

As the compound having flux function, the same compound as described in the above mentioned "(a) Curable resin composition" can be used. Further, the preferred kind, the amount and the like of the compound having flux function are also the same as described therein.

(iii) Other additives

The thermoplastic resin composition may contain additives such as a film-forming resin, a silane coupling agent, a plasticizer, a stabilizing agent, a tackifier, a lubricant, an oxidation inhibitor, an inorganic filler, an antistatic agent and a pigment in addition to the thermoplastic resin component and the compound having flux function. As these additives, the same compounds as described in the above mentioned "(a) Curable resin composition" can be used. Further, the preferred kinds, the amounts and the like of the additives are also the same as described therein.

In this regard, it is preferred that the curable resin composition is used among the above mentioned resin compositions in the present invention. Further, more preferable is a resin composition containing 10 to 90 wt% of the

epoxy resin, 0.1 to 50 wt% of the curing agent, 5 to 50 wt% of the film-forming resin and 1 to 50 wt% of the compound having flux function with respect to a total weight thereof.
Furthermore, even more preferable is a resin composition containing 20 to 80 wt% of the epoxy resin, 0.2 to 40 wt% of the curing agent, 10 to 45 wt% of the film-forming resin and 2 to 40 wt% of the compound having flux function with respect to the total weight thereof. Moreover, especially preferable is a resin composition containing 35 to 55 wt% of the epoxy resin, 0.5 to 30 wt% of the curing agent, 15 to 40 wt% of the film-forming resin and 3 to 25 wt% of the compound having flux function with respect to the total weight thereof.
This makes it possible to sufficiently secure the electrical connecting strength and the mechanical bonding strength between the terminals 21 and 41.
Further, an amount of the curable resin composition or the thermoplastic resin composition contained in the conductive connecting sheet 1, that is, an occupancy amount of the resin composition layers 11 and 13 is set to an appropriate value depending on the type of the resin composition to be used.
Specifically, for example, in the case of the liquid resin composition, the amount thereof is preferably 10 wt% or more, more preferably 20 wt% or more, and even more preferably 25 wt% or more with respect to 100 wt% of the conductive connecting sheet 1. Further, the amount is preferably 95 wt% or less, more preferably 80 wt% or less, and even more preferably 75 wt% or less with respect to 100 wt% of the conductive connecting sheet 1.
Further, in the case of the solid resin composition, the amount thereof is preferably 10 wt% or more, more preferably 15 wt% or more, and even more preferably 20 wt% or more with respect to 100 wt% of the conductive connecting sheet 1. Further, the amount is preferably 95 wt% or less, more preferably 80 wt% or less, and even more preferably 75 wt% or less with respect to 100 wt% of the conductive connecting sheet 1.
If the amount of the resin composition contained in the conductive connecting sheet 1, that is, the occupancy amount of the resin composition layers 11 and 13 falls within the above range, it is possible to sufficiently secure the electrical connecting strength and the mechanical bonding strength between the members to be connected such as the interposer 30.
Further, a thickness of the resin composition layer 11 of the conductive connecting sheet 1 is not limited to a specific value, but is preferably 1 μm or more, more preferably 3 μm or more, and even more preferably 5 μm or more. Further, the thickness of the resin composition layer 11 is preferably 200 μm or less, more preferably 150 μm or less, and even more preferably 100 μm or less.
If the thickness of the resin composition layer 11 falls within the above range, it is possible to sufficiently fill the resin composition into a gap between the adjacent terminals 21 and 41 thereby forming the sealing layer 80. This makes it possible to sufficiently secure the mechanical bonding strength of the cured or hardened resin composition and the electrical connecting strength between the facing terminals 21 and 41, and form the connection portion 81.
In this regard, the conductive connecting sheet 1 of this embodiment has the structure consisting of the two layers of the first resin composition layer 11 and the second resin composition layer 13. The second resin composition layer 13 only has to be the same structure as the above mentioned first resin composition layer 11, and may have the same constitution as the first resin composition layer 11 or may have a different constitution therefrom.
Further, the conductive connecting sheet 1 only has to include the at least one resin composition layer, may exclude any one of the first resin composition layer 11 and the second resin composition layer 13, or may include third and fourth resin composition layers other than the first resin composition layer 11 and the second resin composition layer 13.

<<Metal layer 12>>

The metal layer (metal foil layer) 12 is a layer constituted from a metal foil formed of a metal material having low melting point.
Such a conductive connecting sheet 1 is melted by being heated at a melting point thereof or more. Further, since the resin composition layer 11 contains the compound having flux function, the oxide layer formed on the surface of the metal layer 12 is reduced due to the action thereof, to thereby improve the wettability of the melted metal layer 12. This makes it possible to selectively aggregate the metal layer 12 between the terminals 21 and 41 so that the connection portions 81 are finally formed by a hardened product thereof.
Here, in the present invention, as the metal material having low melting point, appropriately selected is a metal material having a melting point of 330°C or lower, preferably a melting point of 300°C or lower, more preferably a melting point of 280°C or lower, and even more preferably a melting point of 260°C or lower. This makes it possible to effectively suppress or prevent various kinds of members of the semiconductor device 10 from being damaged due to thermal hysteresis during connection between the terminals 21 and 41 of the semiconductor device 10.
Further, from the viewpoint of securing heat resistance of the semiconductor device 10 after formation of the connection portions 81, that is, after connection between the terminals 21 and 41, as the metal material having low melting point, appropriately selected is a metal material having preferably a melting point of 100°C or higher, more

preferably a melting point of 110°C or higher, and even more preferably a melting point of 120°C or higher.

In this regard, it is to be noted that the melting point of the metal material having low melting point, that is, the metal layer 12 can be measured using a differential scanning calorimeter (DSC).

Such a metal material having low melting point is not limited to a specific kind, as long as it has the above melting point and the oxide layer formed on the surface of the metal layer 12 can be removed due to the reduction action of the compound having flux function. Examples of the metal material having low melting point include a metal alloy containing at least two metals selected from the group consisting of tin (Sn), lead (Pb), silver (Ag), bismuth (Bi), indium (In), zinc (Zn), nickel (Ni), antimony (Sb), iron (Fe), aluminum (Al), gold (Au), germanium (Ge) and copper (Cu), tin alone and the like.

Among such metal alloys, it is preferred that the metal material having low melting point is formed of a Sn-Pb metal alloy, a Sn containing metal alloy, which is a Pb-free solder, such as a Sn-Bi metal alloy, a Sn-Ag-Cu metal alloy, a Sn-In metal alloy or a Sn-Ag metal alloy, from the viewpoint of the melting temperature (melting point), the mechanical physical property and the like thereof.

In this regard, in the case where the Sn-Pb metal alloy is used as the metal material having low melting point, an amount of the tin contained therein is preferably 30 wt% or more but less than 100 wt%, more preferably 35 wt% or more but less than 100 wt%, and even more preferably 40 wt% or more but less than 100 wt%. Further, in the case where the Pb-free solder is used as the metal material having low melting point, an amount of the tin contained therein is preferably 15 wt% or more but less than 100 wt%, more preferably 20 wt% or more but less than 100 wt%, and even more preferably 25 wt% or more but less than 100 wt%.

Specifically, examples of the Sn-Pb metal alloy include a Sn-37Pb metal alloy (melting point: 183°C). Further, examples of the Pb-free solder include a Sn-3.0Ag-0.5Cu metal alloy (melting point: 217°C), a Sn-3.5Ag metal alloy (melting point: 221°C), a Sn-58Bi metal alloy (melting point: 139°C), a Sn-9.0Zn metal alloy (melting point: 199°C), a Sn-3.5Ag-0.5Bi-3.0In metal alloy (melting point: 193°C), an Au-20Sn metal alloy (melting point: 280°C), and the like.

Further, a thickness of the metal layer 12 is not limited to a specific value, but is set to an appropriate value depending on a gap size between the facing terminals 21 and 41, a clearance between the adjacent terminals 21 and 41, and the like.

For example, in the case where the terminals 21 and 41 are connected to each other in the semiconductor device 10, the thickness of the metal layer 12 is preferably 0.5 μm or more, more preferably 3 μm or more, and even more preferably 5 μm or more. Further, the thickness is preferably 100 μm or less, more preferably 50 μm or less, and even more preferably 20 μm or less.

If the thickness of the metal layer 12 becomes less than the above lower limit value, there is a fear that an amount of the metal material constituting the metal layer 12 becomes small so that all the terminals 21 and 41 are not connected to each other. On the other hand, if the thickness of the metal layer 12 exceeds the above upper limit value, there is a fear that the amount of the metal material becomes too much so that bridges between the adjacent terminals 21 and 41 are formed through the connection portions 81 to thereby generate a short circuit therebetween.

In this regard, examples of a method for forming the metal layer 12 include, but are not particularly limited to, a method for rolling a block such as an ingot, a method for directly depositing, sputtering or plating the metal material onto the resin composition layer 11, and the like.

Further, an amount of the metal material having low melting point contained in the conductive connecting sheet 1, that is, an occupancy amount of the metal layer 12 contained therein is preferably 5 wt% or more, more preferably 20 wt% or more, and even more preferably 30 wt% or more. Further, the amount is preferably less than 100 wt%, more preferably 80 wt% or less, and even more preferably 75 wt% or less.

If the amount of the metal material having low melting point contained in the conductive connecting sheet 1, that is, the occupancy amount of the metal layer 12 contained therein is less than the above lower limit value, there is a fear that an amount of the metal material constituting the metal layer 12 becomes small so that all the terminals 21 and 41 are not connected to each other. On the other hand, if the amount of the metal material having low melting point exceeds the above upper limit value, there is a fear that the amount of the metal material becomes too much so that bridges between the adjacent terminals 21 and 41 are formed through the connection portions 81 to thereby generate a short circuit therebetween.

Further, the occupancy amount of the metal layer 12 may be defined as a volume ratio thereof with respect to the conductive connecting sheet 1. For example, the occupancy amount (contained amount) of the metal layer 12 is preferably 1 vol% or more, more preferably 5 vol% or more, and even more preferably 10 wt% or more with respect to the conductive connecting sheet 1. Further, the occupancy amount is preferably 90 vol% or less, more preferably 80 vol% or less, and even more preferably 70 vol% or less with respect to the conductive connecting sheet 1.

If the occupancy amount of the metal layer 12 is less than the above lower limit value, there is a fear that an amount of the metal material constituting the metal layer 12 becomes small so that all the terminals 21 and 41 are not connected to each other. On the other hand, if the occupancy amount exceeds the above upper limit value, there is a fear that the amount of the metal material becomes too much so that bridges between the adjacent terminals 21 and 41 are formed

through the connection portions 81 to thereby generate a short circuit therebetween.

In this embodiment, as shown in FIG. 2, the metal layer 12 is formed on the entire surface of the resin composition layer 11. However, the metal layer 12 only has to be formed on a part of the surface of the resin composition layer 11, and a shape thereof is not limited to a specific type.

Namely, in the case where the metal layer 12 is formed on a part of the surface of the resin composition layer 11, metal layer units each having a predetermined shape may be repeatedly provided in a regular pattern, may be provided in an irregular pattern, or may be provided in a regular pattern and an irregular pattern.

Specifically, in FIG. 3, a metal layer 12 having a predetermined pattern is formed on the surface of the resin composition layer 11. Examples of the shape of the metal layer 12 include (a) a pattern shape in which dotted lines are removed from a square shape, (b) a striped pattern shape, (c) a polka-dotted pattern shape, (d) a square-dotted pattern shape, (e) a checker pattern shape, (f) a frame pattern shape, (g) a lattice pattern shape, (h) a multiple frame pattern shape, and the like.

In this regard, each of the above shapes is one example of the shape of the metal layer 12. These shapes can be used by being combined with each other or modified depending on a purpose or an intended use of the metal layer 12.

Further, examples of a method for forming the metal layer units repeatedly provided include, but are not particularly limited to, a method for punching a planar metal foil into a predetermined pattern, a method for etching the planar metal foil into a predetermined pattern, a method for depositing, sputtering or plating the metal material through a shield, a mask or the like, and the like.

A type of the above mentioned conductive connecting sheet 1 is appropriately set depending on the type of the resin composition constituting the resin composition layer 11 and the like.

For example, in the case of the liquid curable resin composition, the conductive connecting sheet 1 can be produced by preparing the metal layer 12, applying the liquid curable resin composition onto both surfaces thereof, and then semi-curing it (bringing it into a B stage state) at a predetermined temperature to thereby obtain the resin composition layers 11 and 13, and used.

Further, in this case, the conductive connecting sheet 1 can be also produced by applying the liquid curable resin composition onto a releasing substrate such as a polyester sheet, semi-curing it (bringing it into a B stage state) at a predetermined temperature to obtain a film, peeling off the film from the releasing substrate, and then attaching it to the metal layer 12 to thereby be formed into a film shape, and used.

On the other hand, in the case of the solid curable resin composition, the conductive connecting sheet 1 can be produced by preparing a varnish in which the solid resin composition is dissolved into an organic solvent, applying the varnish onto a releasing substrate such as a polyester sheet, drying it at a predetermined temperature to form the resin composition layer 11, and then attaching it to the metal layer 12, and used.

Further, in this case, the conductive connecting sheet 1 can be also produced by forming the metal layer 12 onto the resin composition layer 11 obtained in the same manner as described above using a technique such as vapor deposition, to thereby be formed into a film shape, and used.

In this regard, it is to be noted that the metal layer 12 may be subjected to an embossing, in order to improve the adhesiveness with respect to the resin composition layer 11.

Further, a thickness of the conductive connecting sheet 1 is not limited to a specific value, but is preferably 1 μm or more, more preferably 3 μm or more, and even more preferably 5 μm or more. Further, the thickness is preferably 200 μm or less, more preferably 150 μm or less, and even more preferably 100 μm or less.

If the thickness of the conductive connecting sheet 1 falls within the above range, it is possible to sufficiently fill the sealing layer 80 constituted from the resin composition into the gap between the adjacent terminals 21 and 41. Further, it is also possible to sufficiently secure the mechanical bonding strength of the cured or hardened resin component and the electrical connecting strength between the facing terminals 21 and 41. Furthermore, it is also possible to form the connection portions 81 suitable for the purpose or the intended use thereof.

<Method for producing conductive connecting sheet>

The above mentioned conductive connecting sheet 1 can be, for example, produced using the following production method.

(i) In the case where the resin composition is of a liquid state at 25°C

In the case where the resin composition constituting the first resin composition layer 11 and the second resin composition layer 13 is of a liquid state at 25°C, first, the metal layer 12 is prepared.

The metal layer 12 can be formed by rolling a block such as an ingot.

Next, the metal layer 12 is dipped into the liquid resin composition to attach it onto both the surfaces of the metal layer 12, and then the attached liquid resin composition is semi-cured at a predetermined temperature. In this way, the conductive connecting sheet 1 in which the resin composition layers 11 and 13 are formed on both the surfaces of the metal layer 12 can be produced.

In this regard, in the case where thicknesses of the resin composition layers 11 and 13 to be formed has to be controlled, the resin composition layers 11 and 13 having desired thicknesses can be easily formed by passing the metal layer 12 dipped into the liquid resin composition through a bar coater including bars provided in a constant distance or by spraying the liquid resin composition to the metal layer 12 using a spray coater or the like.

(ii) In the case where the resin composition is of a solid state at 25°C

In the case where the resin composition constituting the first resin composition layer 11 and the second resin composition layer 12 is of a solid state at 25°C, first, a releasing base member such as a polyesters sheet is prepared.

Next, a varnish obtained by dissolving the solid resin composition into an organic solvent is applied onto the releasing base member, and then dried at a predetermined temperature. In this way, a film-like resin composition is formed.

Next, two film-like resin compositions are prepared according to the above step, the metal layer 12 which has been, in advance, formed is put between the film-like resin compositions, and then they are layered using a heat rollers. In this way, the conductive connecting sheet 1 in which the resin composition layers 11 and 13 are formed on both the surfaces of the metal layer 12 can be produced.

In this regard, in the case where a rolled metal layer 12 is used, the metal layer 12 is employed as a base member, the above mentioned film resin compositions are layered on both the surfaces of the metal layer 12 using a heat rollers, and then they are rolled. In this way, a rolled conductive connecting sheet 1 can be produced.

Further, in the case where the rolled metal layer 12 is used, the varnish obtained in the same manner as described above is directly applied onto both the surfaces of the metal layer 12 and dried due to vaporization of a solvent, and then they are rolled. In this way, the rolled conductive connecting sheet 1 can be also produced.

Further, in this regard, a conductive connecting sheet including the patterned metal layer is produced, for example, a sheet metal layer is placed onto a releasing base member, and then an unnecessary portion is removed by half-cutting the metal layer from a side thereof using a die. In this way, first, the pattered metal layer is formed.

Next, the film-like resin composition obtained using the above mentioned method is place onto a surface of the metal layer opposite to the releasing base member, they are layered together using a heat rollers, and then the releasing base member is peeled off from the metal layer.

Further, the film-like resin composition obtained using the above mentioned method is place onto a surface of the metal layer opposite from which the releasing base member has been peeled off, and then they are layered together using the heat rollers. In this way, a conductive connecting sheet in which resin composition layers are formed on both the surfaces of the metal layer can be produced.

In this regard, it is to be noted that the method for producing the conductive connecting sheet is not limited to the above mentioned method, but can be appropriately selected depending on the purpose or the intended use thereof.

The conductive connecting sheet described above is used for forming the connection portions 81 and the sealing layer 80 with which the semiconductor device 10 is provided.

In the formation of the connection portions 81 and the sealing layer 80 using the conductive connecting sheet 1, a method for connecting terminals or a method for forming connection terminal according to the present invention is used.

<Method for connecting terminals>

Hereinbelow, first, detailed description will be made on a case that the connection portions 81 and the sealing layer 80 are formed using the method for connecting terminals according to the present invention.

FIG. 4 is a vertical section view explaining a method for forming the connection portions and the sealing layer with which the semiconductor device is provided using the method for connecting terminals of the present invention, and FIG. 5 is a vertical section view explaining a method for measuring a wet extension of metal balls according to JIS Z 3197. In the following description, an upper side and a lower side in FIG. 4 will be referred to as "upper" and "lower", respectively.

A method for forming the connection portions 81 and the sealing layer 80 described below (that is, the method for connecting terminals according to the present invention) includes: a placement step of placing the conductive connecting sheet 1 between facing terminals; a heat step of heating the conductive connecting sheet 1; and a curing/hardening step of curing or hardening the resin composition.

In this regard, when the connection portions 81 and the sealing layer 80 are formed, formation methods therefor are slightly different from each other between the case that the resin composition layers 11 and 13 of the conductive connecting sheet 1 are formed of the curable resin composition and the case that they are formed of the thermoplastic resin composition.

Therefore, hereinbelow, descriptions will be made on a first embodiment in which the resin composition layers 11 and 13 of the conductive connecting sheet 1 are formed of the curable resin composition and a second embodiment in which they are formed of the thermoplastic resin composition.

<<First embodiment>>

The first embodiment in which the resin composition layers 11 and 13 of the conductive connecting sheet 1 are formed of the curable resin composition include: a placement step of placing the conductive connecting sheet 1 between the semiconductor chip 20 and the interposer 30 on which the wiring pattern 40 is provided; a heat step of heating the conductive connecting sheet 1 at a temperature which is a melting point of the metal material or more and at which curing of the curable resin composition is not finished; and a curing step of finishing the curing of the curable resin composition.

Hereinbelow, each of the steps will be described in detail.

[1] Placement step

First, the semiconductor chip 20 and the interposer 30 on which the wiring pattern 40 is provided are prepared.

Next, the conductive connecting sheet 1 is thermally compression bonded to a surface of the interposer 30 on which the wiring pattern 40 is provided using a machine such as a roll laminator or a presser.

In this state, as shown in FIG. 4(a), the semiconductor chip 20 and the wiring pattern 40 provided on the interposer 30 are aligned so that the terminals 21 face to the terminals 41.

In this way, the conductive connecting sheet 1 is placed between the semiconductor chip 20 and the wiring pattern 40 provided on the interposer 30 in the state that the terminals 21 face to the terminals 41.

In this regard, as shown in FIG. 4(a), the conductive connecting sheet 1 is thermally compression bonded to the interposer 30, but may be thermally compression bonded to the semiconductor chip 20 or may be thermally compression bonded to both the interposer 30 and the semiconductor chip 20.

[2] Heat step

Next, as shown in FIG. 4(b), the conductive connecting sheet 1 placed between the semiconductor chip 20 and the wiring pattern 40 provided on the interposer 30 in the placement step [1] is heated at a temperature which is a melting point of the metal layer 12 or higher.

A heat temperature only has to be the melting point of the metal layer 12 or higher. Therefore, an upper limit value thereof is not limited to a specific value as long as the heat temperature is a degree that the metal material can move in the curable resin composition, that is, a degree that "the curing of the curable resin composition is not finished" by adjusting a heat time (e.g., by shortening the heat time).

Specifically, the heat temperature is preferably a temperature 5°C or more higher than the melting point of the metal layer 12, more preferably a temperature 10°C or more higher than the above melting point, even more preferably a temperature 20°C or more higher than the above melting point, and especially preferably a temperature 30°C or more higher than the above melting point.

Further, the heat temperature is set to an appropriate value depending on the constitutions or the like of the metal layer 12 and curable resin composition to be used, but is preferably 100°C or more, more preferably 130°C or more, even more preferably 140°C or more, and especially preferably 150°C or more.
In this regard, from the viewpoint that the semiconductor chip 20 to be connected, the interposer 30 to be connected and the like are prevented from thermally deteriorating, the heat temperature is preferably 260°C or less, more preferably 250°C or lower, and even more preferably 240°C or lower.

In the case where the conductive connecting sheet 1 is heated at such a temperature, the metal layer 12 is melted. As a result, the melted metal layer 12, that is, the melted metal material having low melting point comes to be able to move in the resin composition layers 11 and 13.

At this time, the oxide layer formed on the surface of the metal layer 12 is removed by being reduced due to the reduction action of the compound having flux function contained in the curable resin composition. For this reason, the wettability of the melted metal material is improved so that a metal bond thereof is enhanced. Therefore, the melted metal material can be easily aggregated between the terminals 21 and 41 provided so as to face to each other.

Further, the oxide layers formed on the surfaces of the terminals 21 and 41 are also removed by being reduced due to the reduction action of the compound having flux function, to thereby improve the wettability thereof. As a result, a metal bond thereof with respect to the metal material is also enhanced. Also for this reason, the melted metal material also can be easily aggregated between the facing terminals 21 and 41.

In the present invention, since the metal layer 12 is of the layer shape (foil shape), when the melted metal layer 12 is separated into a plurality of parts and aggregated on the surfaces of the terminals 21 and 41, it is possible to appropriately suppress or prevent a part of the melted metal layer 12 from existing within the resin composition layers 11 and 13 without being aggregated on the terminals 41. This makes it possible to reliably prevent the generation of the leak current due to the existence of a part of the metal layer 12 within the sealing layer 80.

For these reasons, the melted metal material moves within the curable resin component and is selectively aggregated between the terminals 21 and 41. As a result, as shown in FIG. 4(C), the connection portions 81 each formed of the metal material are formed between the terminals 21 and 41 so that the terminals 21 and the terminals 41 are connected to each other through the connection portions 81.
At this time, the curable resin composition is filled so as to surround the connection portions 81 to thereby form the sealing layer 80. As a result, it is possible to secure the insulating property between the adjacent terminals 21 and 41. This makes it possible to prevent the adjacent terminals 21 and 41 from being shorted.
Through the above steps, the connection portions 81 and the sealing layer 80 are formed. However, in the case where the pitch between the adjacent terminals 21 and 41 is narrow, there was a problem in that the melted metal material is not selectively aggregated between the facing terminals 21 and 41, which causes the generation of the leak current between the adjacent terminals 21 and 41.
After an exhaustive study of solving such a problem by the present inventors, it was gradually revealed that if the flux activity of the resin composition contained in the resin composition layers 11 and 13 is lowered, the melted metal material cannot be high selectively aggregated between the terminals 21 and 41.
A further study of the present inventors has revealed that the above mentioned problem can be solved by appropriately selecting the components contained in the resin composition layers 11 and 13 so that in the case where at least a part of metal ball(s) made of the metal material having low melting point is provided within the resin composition layers 11 and 13, the metal ball(s) is heated at a temperature which is a melting temperature thereof or more according to "test methods for soldiering resin type fluxes" defined in JIS Z 3197, and then a wet extension of the metal ball is measured, the wet extension becomes 37% or more. As a result, the present inventors have completed the present invention.
Here, the wet extension "S" [%] of the metal ball(s) to be obtained according to the "test methods for soldering resin type fluxed" defined in JIS Z 3197 can be calculated by measuring a diameter of the metal ball(s) before being heated is defined as "D" [mm] and a height of the metal ball(s) after being heated is defined as "H" [mm], and using the following formula 1 based on these measured values.
$$S\ [\%] = (D-H)/D \times 100 \cdots \text{formula 1}$$

More specifically, first, prepared is a copper plate 90 (for example, length: 1.0 cm × width: 1.0 cm × height: 0.3 mm). Next, a resin composition layer 11 having a thickness of 30 μm is formed on the copper plate 90, and then metal balls 91 each having a diameter "D" of 0.5 mm are placed on the resin composition layer 11 (see FIG. 5(a)).
As the metal ball 91 to be used for measuring the wet extension include, a metal ball formed of a metal alloy containing at least two metals selected from the group consisting of tin (Sn), lead (Pb), silver (Ag), bismuth (Bi), indium (In), zinc (Zn), nickel (Ni), antimony (Sb), iron (Fe), aluminum (Al), gold (Au), germanium (Ge) and copper (Cu), or tin alone can be used, but is not particularly limited thereto.
Among them, it is preferred that a metal ball formed of a Sn-Pb metal alloy, a Sn-Ag-Cu metal alloy or a Sn-Ag metal alloy as a major component thereof can be used, and more preferred that a metal ball formed of a Sn-37Pb metal alloy (melting point: 183°C) or a Sn-3.0Ag-0.5Cu metal alloy (melting point: 217°C) as a major component thereof can be used.
In the case where the wet extension measured using the metal balls 91 formed of such a metal alloy becomes 37% or more, it is possible to more selectively aggregate the melted metal material between the facing terminals 21 and 41. As a result, the occurrence of the leak current between the adjacent terminals 21 and 41 can be appropriately prevented or suppressed.
Next, the metal balls 91 placed on the resin composition layer 11 are compression bonded using a thermocompression bonding machine (e.g., "TMV1-200ABS" produced by TSUKUBA MECHANIX). In this way, at least a part of the metal balls 91 is embedded into the resin composition layer 11 (see FIG. 5(b)).
In this regard, the at least a part of the metal balls 91 only has to be embedded into the resin composition layer 11 by being compression bonded. However, it is preferred that a part having about 1/100 to 3/50 of the diameter "D" [mm] of each metal ball 91 is embedded thereinto, and more preferred that a part having about 1/50 to 3/50 of the above diameter "D" is embedded thereinto.
If the part of each metal ball 91 falling within the above range is embedded into the resin composition layer 11, the oxide layer formed on each metal ball 91 can be removed by the compound having flux function contained in the resin composition layer 11.
Further, the conditions under which the metal balls 91 are compression bonded to the resin composition layer 11 are, for example, set to a load of 50 N, a temperature of 80 °C and a time of 5 seconds, but are not limited thereto.
Next, by heating the metal balls 91 at a temperature higher than the melting point of the metal material having

low melting point constituting the metal balls 91, the metal balls 91 are melted (see FIG. (C)).

A temperature of heating the metal balls 91 only has to be higher than the melting point of the metal material, but is preferably a temperature 10°C or more higher than the melting point of the metal material, and more preferably a temperature 30°C or more higher than the melting point of the metal material.

Further, a time of heating the metal balls 91 is preferably 5 seconds or more, and more preferably about 20 seconds.

By setting the conditions of heating the metal balls 91 to values each falling within the above range, the entireties of the metal balls 91 can be substantially uniformly melted.

Here, oxide layers formed on surfaces of the melted metal balls 91 are removed by being reduced due to the reduction action of the compound having flux function contained in the resin composition layer 11. For this reason, the melted metal balls 91 wetly extend on the copper plate 90. Therefore, in the case where the compound having flux function sufficiently exhibits the reduction action thereof, the melted metal balls 91 widely extend on the copper plate 90. Contrariwise, in the case where the compound having flux function insufficiently exhibits the reduction action thereof, the melted metal balls 91 do not widely extend on the copper plate 90.

Next, the melted metal balls 91 are hardened by being cooled, and then the resin composition layer 11 is dissolved into a solvent so that it is removed from the copper plate 90 (see FIG. 5(d)).

In this regard, as the solvent, the same solvent as described in the curable resin composition (a), which is used for preparing the curable resin composition, can be used.

Next, the height "H" [mm] of each metal ball 91 exposed on the copper plate 90 by removing the resin composition layer 11 is measured, and then the wet extension "S" [%] of the metal balls 91 is obtained using the above formula 1.

According to the present invention, in the case where the wet extension "S" [%] of the metal balls 91 obtained using the above formula 1 is 37% or more, the compound having flux function is sufficiently exhibiting the reduction action thereof in the resin composition layer 11, so that the oxide layer formed on the metal layer 12 can be reliably removed by the reduction action. As a result, it is possible to reliably aggregate the melted metal material between the facing terminals 21 and 41. This makes it possible to appropriately prevent or suppress the generation of the leak current between the adjacent terminals 21 and 41.

Further, the wet extension "S" only has to be 37% or more, but is preferably 50% or more, and more preferably 50% or more. This makes it possible to more reliably aggregate the melted metal material between the facing terminals 21 and 41. Further, this also makes it possible to appropriately prevent or suppress lowering of moisture resistance of the sealing layer 80 which would occur due to an excess amount of the compound having flux function.

Furthermore, a further study of the present inventors has revealed that there is a correlation between the wet extension "S" of the metal balls 91 and an acid value of the resin composition layer 11, and thus the wet extension "S" of the metal balls 91 can be more reliably set to 37% or more by adjusting the acid value of the resin composition layer 11 to a value of $3.0\times10^{-5}$ to $1.0\times10^{-2}$ mol/g.

Here, in this specification, the acid value of the resin composition layer 11 can be obtained based on "petroleum products and lublicants-Determination of neutralization number" defined in JIS K 2501.

Specifically, in the measurement of the acid value of the resin composition layer 11, the resin composition constituting the resin composition layer 11 (about 0.2 g) is dissolved into acetone (100 mL) to prepare a resin composition solution, this resin composition solution is titrated with a sodium hydroxide aqueous solution (0.05 mol/L) using a potentiometric titration, and a titration curve is drawn using a potential automatic titrator (e.g., "AT-500N" produced by KYOTO ELECTRONICS MANUFACTURING CO., LTD.).

And, by defining a weight of the resin composition as M [g], a concentration of the sodium hydroxide aqueous solution as C [mol/L] and an amount of the sodium hydroxide aqueous solution dropped (titrated) up to an end point, which is an inflection point on the drawn titration curve, as A [L], the acid value can be calculated using the following formula 2.

$$\text{Acid value [mol/g]} = (A\times C)/M \cdots \text{formula 2}$$

The acid value of the resin composition layer 11 is preferably in the range of $3.0\times10^{-5}$ to $1.0\times10^{-2}$ mol/g, and more preferably in the range of $8\times10^{-5}$ to $5\times10^{-3}$ mol/g. This makes it possible to more reliably set the wet extension of the metal balls 91 to 37% or more.

Further, an amount of the compound having flux function contained in the resin composition layer 11, that is, the resin composition slightly varies depending on the kind of the compound having flux function to be selected, but is preferably in the range of about 1 to 50 wt%, more preferably in the range of about 2 to 40 wt%, and even more preferably in the range of about 3 to 25 wt%. This makes it possible to reliably set the acid value of the resin composition layer 11 to a value within the range of $3.0\times10^{-5}$ to $1.0\times10^{-2}$ mol/g.

Furthermore, as the compound having flux function, the aliphatic carboxylic acid represented by the above formula (1) or the aromatic carboxylic acid represented by the above formula (2) or (3) is preferably used among the above mentioned carboxylic acids. By selecting such compounds as the compound having flux function, it is possible to more reliably set the acid value of the resin composition layer 11 to a value within the above range.

According to such a method for forming the connection portions 81 and the sealing layer 80 using the conductive connecting sheet 1 described above, the connection portions 81 can be formed by selectively aggregating the heated and melted metal material between the terminals 21 and 41 and the sealing layer 80 constituted from the curable resin composition can be formed so as to surround the connection portions 81.

As a result, since the generation of the leak current between the adjacent terminals 21 and 41 is reliably prevented by securing the insulating property therebetween, it is possible to improve the connection reliability between the terminals 21 and 41 through the connection portions 81.

Further, also in a fine pitch circuit, electrical connection of a plurality of terminals 21 and 41 can be carried out all at once. Furthermore, by curing the curable resin composition in the next step [3], it is possible to improve the mechanical strengths of the connection portions 81 and the sealing layer 80.

In this regard, during this step [2], the semiconductor chip 20 and the interposer 30 may be heated in a state that they are compressed so that the facing terminals 21 and 41 are made close to each other. For example, in FIG. 4 (b), by heating and compressing the semiconductor chip 20 and the interposer 30 using a means such as a well-known thermocompression bonding machine in a direction of making them close to each other, it is possible to constantly control a distance between the facing terminals 21 and 41. This makes it possible to improve the electrical connection reliability between the facing terminals 21 and 41 through the connection portions 81.

Further, during the compression and the heat, ultrasound, an electric field or the like may be applied to the conductive connecting sheet 1, specific heat using laser, electromagnetic induction or the like may be used.

[3] Curing step

Next, after the connection portions 81 and the sealing layer 80 have been formed in the heat step [2], by curing the curable resin composition, the sealing layer 80 is fixed (secured).

This makes it possible to sufficiently secure both the electrical reliability between the terminals 21 and 41 by the connection portions 81 and the mechanical reliability by the sealing layer 80.

In this embodiment, especially, by using the curable resin composition having insulating resistance during high melting viscosity, it is possible to more reliably secure the insulating property of the sealing layer (insulating area) 80.

The curing of the curable resin composition can be carried out by heating the curable resin composition. A temperature for curing the curable resin composition can be appropriately set depending on the constitution of the curable resin composition. Specifically, the temperature is preferably a temperature at least 5°C lower than the heat temperature in the heat step [2], and more preferably a temperature at least 10°C lower than the heat temperature.

More specifically, the temperature is preferably 100°C or higher, more preferably 120°C or higher, even more preferably 130°C or higher, and especially preferably 150°C or higher. Further, the temperature is preferably 300°C or lower, more preferably 260°C or lower, even more preferably 250°C or lower, and especially preferably 240°C or lower. If the curing temperature falls within the above range, it is possible to sufficiently cure the curable resin composition, while reliably preventing the conductive connecting sheet 1 from being thermally recomposed.

Through the above steps, the connection portions 81 and the sealing layer 80 are formed between the semiconductor chip 20 and the interposer 30 on which the wiring pattern 40 is provided.

<<Second embodiment>>

The second embodiment in which the resin composition layers 11 and 13 of the conductive connecting sheet 1 are formed of the thermoplastic resin composition include: an placement step of placing the conductive connecting sheet 1 between the semiconductor chip 20 and the interposer 30 on which the wiring pattern 40 is provided; a heat step of heating the conductive connecting sheet 1 at a temperature which is a melting point of the metal material or higher and at which the thermoplastic resin composition constituting the resin composition layers 11 and 13 is softened; and a hardening step of hardening the thermoplastic resin composition.

Hereinbelow, each of the steps will be described in detail.

[1] Placement step

Also in this embodiment in which the resin composition layers 11 and 13 are formed of the thermoplastic resin composition, the conductive connecting sheet 1 is placed between the semiconductor chip 20 and the wiring pattern 40 provided on the interposer 30 in a state that the terminals 21 face to the terminals 41 in the same manner as described

in the first embodiment in which the resin composition layers 11 and 13 are formed of the curable resin composition.

[2] Heat step

Next, as shown in FIG. 4(b), the conductive connecting sheet 1 placed between the semiconductor chip 20 and the interposer 30 on which the wiring pattern 40 is provided in the placement step [1] is heated at a temperature which is a melting point of the metal layer 12 or higher.
A heat temperature is preferably a temperature 5°C or more higher than the melting point of the metal layer 12, more preferably a temperature 10°C or more higher than the above melting point, even more preferably a temperature 20°C or more higher than the above melting point, and especially preferable a temperature 30°C or more higher than the above melting point.
Specifically, the heat temperature is set to an appropriate value depending on the constitutions or the like of the metal layer 12 and the thermoplastic resin composition, but is, for example, set to a value within the same temperature range as described in the heat step [2] of the above mentioned first embodiment.
In the case where the conductive connecting sheet 1 is heated at such a temperature, the metal layer 12 is melted. As a result, the melted metal layer 12, that is, the melted metal material having low melting point comes to be able to move in the resin composition layers 11 and 13.
At this time, since the kind and the amount of the compound having flux function contained in the Thermoplastic resin composition is set so that the wet extension of the metal balls 91 becomes 37% or more in the present invention, the oxide layer formed on the surface of the metal layer 12 is reliably removed by being reduced due to the reduction action of the compound having flux function. For this reason, the wettability of the melted metal material is improved so that a metal bond thereof is enhanced. Therefore, the melted metal material can be easily aggregated between the terminals 21 and 41 provided so as to face to each other.
Further, in the present invention, since the metal layer 12 is of the layer shape (foil shape), when the melted metal layer 12 is separated into a plurality of parts and aggregated on the surfaces of the terminals 41, it is possible to appropriately suppress or prevent a part of the melted metal layer 12 from existing within the resin composition layers 11 and 13 without being aggregated on the terminals 41. This makes it possible to reliably prevent the generation of the leak current due to the existence of a part of the metal layer 12 within the sealing layer 80.
Furthermore, the oxide layers formed on the surfaces of the terminals 21 and 41 are also removed by being reduced due to the reduction action of the compound having flux function, to thereby improve the wettability thereof. As a result, a metal bond thereof with respect to the metal material is also enhanced. Also for this reason, the melted metal material also can be easily aggregated between the facing terminals 21 and 41.
For these reasons, the melted metal material moves within the Thermoplastic resin component and is selectively aggregated between the terminals 21 and 41. As a result, as shown in FIG. 4(C), the connection portions 81 each formed of the metal material are formed between the terminals 21 and 41 so that the terminals 21 and the terminals 41 are connected to each other through the connection portions 81.
At this time, the Thermoplastic resin composition is filled so as to surround the connection portions 81 to thereby form the sealing layer 80. As a result, it is possible to secure the insulating property between the adjacent terminals 21 and 41. This makes it possible to reliably prevent the adjacent terminals 21 and 41 from being shorted.
According to such a method for forming the connection portions 81 and the sealing layer 80, the connection portions 81 can be formed by selectively aggregating the heated and melted metal material between the terminals 21 and 41 and the sealing layer 80 constituted from the thermoplastic resin composition can be formed so as to surround the connection portions 81.
As a result, since the generation of the leak current between the adjacent terminals 21 and 41 is reliably prevented by securing the insulating property therebetween, it is possible to improve the connection reliability between the terminals 21 and 41 through the connection portions 81.
Further, also in a fine pitch circuit, electrical connection of a plurality of terminals 21 and 41 can be carried out all at once. Furthermore, by hardening the thermoplastic resin composition in the next step [3], it is possible to improve the mechanical strengths of the connection portions 81 and the sealing layer 80.

[3] Hardening step

Next, after the connection portions 81 and the sealing layer 80 have been formed in the heat step [2], by hardening the thermoplastic resin composition, the sealing layer 80 is fixed (secured).
This makes it possible to sufficiently secure both the electrical reliability between the terminals 21 and 41 by the connection portions 81 and the mechanical reliability by the sealing layer 80.
The hardening of the thermoplastic resin composition can be carried out by cooling the Thermoplastic resin composition which has been heated in the heat step [2].

A method for hardening the Thermoplastic resin composition by cooling the Thermoplastic resin composition, that is, a method for fixing the sealing layer 80 is appropriately selected depending on the constitution of the thermoplastic resin composition. Specifically, such a method is appropriately selected from a method for naturally cooling the thermoplastic resin composition, a method for spraying cool air to the Thermoplastic resin composition and the like.

A hardening temperature of the Thermoplastic resin composition is not limited to a specific value, but is preferably lower than the melting point of the metal layer 12. Specifically, the hardening temperature of the thermoplastic resin composition is preferably a temperature 10°C or more lower than the melting point of the metal layer 12, and more preferably 20°C or more lower than the above melting point. Further, the hardening temperature of the Thermoplastic resin composition is preferably 50°C or higher, more preferably 60°C or higher, and even more preferable 100°C or higher. If the hardening temperature of the Thermoplastic resin composition falls within the above range, the connection portions 81 can be reliably formed and the sealing layer 80 can exhibit excellent heat resistance. As a result, it is possible to appropriately secure the insulating property between the adjacent terminals 21 and 41 and to more reliably prevent the adjacent terminals 21 and 41 from being shorted.

Through the above steps, the connection portions 81 and the sealing layer 80 are formed between the semiconductor chip 20 and the interposer 30 on which the wiring pattern 40 is provided.

In this regard, the present invention is used for electrically connecting the terminals 21 of the semiconductor chip 20 and the terminals 41 of the wiring pattern 40 to each other by forming the connection portions 81 in the first embodiment and the second embodiment, but is not limited to such an use. The present invention can be used for electrically connecting terminals of electronic components provided in various kinds of electronic devices. Examples of the electronic components include a semiconductor wafer, a rigid substrate, a flexible substrate and the like.

<Method for forming connection terminal according to the present invention>

Next, description will be made on a case that the connection portions 81 and the sealing layer 80 are formed using the method for forming connection terminal according to the present invention.

In this case, first, connection terminals 85 and a reinforcing layer 86 are formed on the surface of the semiconductor chip 20 on which the terminals 21 are provided, and then the semiconductor chip 20 on which the connection terminals 85 and the reinforcing layer 86 have been formed is bonded (mounted) to the surface of the interposer 30 on which the wiring pattern 40 is provided. In this way, the connection portions 81 and the sealing layer 80 are formed.

Hereinbelow, detailed description will be made on a method for forming the connection terminals 85 and the reinforcing layer 86 onto the surface of the semiconductor chip 20 on which the terminals 21 are provided.

FIG. 6 is a vertical section view explaining the method for forming the connection terminals so as to correspond to the terminals of the semiconductor chip. In the following description, an upper side and a lower side in FIG. 6 will be referred to as "upper" and "lower", respectively.

The method for forming the connection terminals 85 and the reinforcing layer 86 described below include: an placement step of plating the conductive connecting sheet 1 onto the surface of the semiconductor chip 20 on which the terminals 21 are provided; and a heat step of heating the conductive connecting sheet 1.

In this regard, when the connection terminals 85 and the reinforcing layer 86 are formed, formation methods therefor are slightly different from each other between the case that the resin composition layers 11 and 13 of the conductive connecting sheet 1 are formed of the curable resin composition and the case that they are formed of the Thermoplastic resin composition.
Therefore, hereinbelow, descriptions will be made on a third embodiment in which the resin composition layers 11 and 13 of the conductive connecting sheet 1 are formed of the curable resin composition and a fourth embodiment in which they are formed of the thermoplastic resin composition.

<<Third embodiment>>

The third embodiment in which the resin composition layers 11 and 13 of the conductive connecting sheet 1 are formed of the curable resin composition include: an placement step of placing the conductive connecting sheet 1 onto the surface of the semiconductor chip 20 on which the terminals 21 are provided; a heat step of heating the conductive connecting sheet 1 at a temperature which is a melting point of the metal material or higher and at which curing of the resin composition is not finished.

Hereinbelow, each of the steps will be described in detail.

[1] Placement step

First, as shown in FIG. 6 (a), the semiconductor chip 20 provided with the terminals 21 at a side of a lower surface thereof is prepared.

Next, the conductive connecting sheet 1 is thermally compression bonded to (placed on) the surface of the semiconductor chip 20 on which the terminals 21 are provided using a machine such as a roll laminator or a presser.

In this way, the conductive connecting sheet 1 makes contact with the terminals 21 exposed in the surface of the semiconductor chip 20 on which the terminals 21 is provided.

[2] Heat step

Next, as shown in FIG. 6(b), the conductive connecting sheet 1 (metal layer 12) placed on the surface of the semiconductor chip 20 on which the terminals 21 is provided in the placement step [1] is heated at a temperature which is a melting point of the metal layer 12 or higher.

A temperature for heating the conductive connecting sheet 1 is set to the same temperature at which the conductive connecting sheet 1 is heated in the heat step [2] of the first embodiment.

In the case where the conductive connecting sheet 1 is heated at such a temperature, the metal layer 12 is melted. As a result, the melted metal layer 12, that is, the melted metal material having low melting point comes to be able to move in the resin composition layers 11 and 13.

At this time, since the kind and the amount of the compound having flux function contained in the curable resin composition is set so that the wet extension of the metal balls 91 becomes 37% or more in the present invention, the oxide layer formed on the surface of the metal layer 12 is reliably removed by being reduced due to the reduction action of the compound having flux function. For this reason, the wettability of the melted metal material is improved so that a metal bond thereof is enhanced. Therefore, the melted metal material can be easily aggregated onto the surfaces of the terminals 21.

Further, the oxide layers formed on the surfaces of the terminals 21 are also removed by being reduced due to the reduction action of the compound having flux function, to thereby improve the wettability thereof. As a result, a metal bond thereof with respect to the metal material is also enhanced. Also for this reason, the melted metal layer 12 also can be easily aggregated onto the surfaces of the terminals 21.

Furthermore, in the present invention, since the metal layer 12 is of the layer shape (foil shape), when the melted metal layer 12 is separated into a plurality of parts and aggregated onto the surfaces of the terminals 21, it is possible to appropriately suppress or prevent a part of the melted metal layer 12 from existing within the resin composition layers 11 and 13 without being aggregated on the terminals 21. This makes it possible to reliably prevent the generation of the leak current due to the existence of a part of the metal layer 12 within the reinforcing layer 86.

For these reasons, the melted metal material moves within the resin composition layers 11 and 13, that is, the curable resin composition and is selectively aggregated onto the surfaces of the terminals 21. In this state, by cooling the conductive connecting sheet 1, as shown in FIG. 6(C), the connection terminals 85 each formed of the hardened metal material are formed on the surfaces of the terminals 21.

At this time, the curable resin composition is filled so as to surround the connection terminals 85 to thereby form the reinforcing layer 86. As a result, it is possible to secure the insulating property between the adjacent connection terminals 85. This makes it possible to reliably prevent the adjacent connection terminals 85 from being shorted.

According to such a method for forming the connection terminals 85 and the reinforcing layer 86, the connection terminals 85 can be formed by selectively aggregating the heated and melted metal material onto the terminals 21 and the reinforcing layer 86 constituted from the curable resin composition can be formed so as to surround the connection terminals 85. As a result, it is possible to secure the insulating property between the adjacent connection terminals 85.

Further, also in a semiconductor chip 20 having a plurality of terminals 21 provided at a fine pitch, the plurality of connection terminals 85 can be formed so as to correspond to the terminals 21 all at once.

In this regard, during this step [2], the conductive connecting sheet 1 and the semiconductor chip 20 may be heated in a state that they are compressed so that the conductive connecting sheet 1 and the terminals 21 are made close to each other. For example, in FIG. 6(b), by heating and compressing the conductive connecting sheet 1 and the semiconductor chip 20 using a means such as a well-known thermal compression bonding machine in a direction of making them close to each other, it is possible to constantly control a distance between the conductive connecting sheet 1 and the terminals 21. This makes it possible to improve aggregation capacity of the melted metal material onto the surfaces of the terminals 21.

Further, during the compression or the heat, ultrasound, an electric field or the like may be applied to the conductive connecting sheet 1, specific heat using laser, electromagnetic induction or the like may be used.

Through the above step [1] and the above step [2], the connection terminals 85 and the reinforcing layer 86 are formed. That is, the method for forming connection terminals according to the present invention is used in the placement step [1] and the heat step [2] for forming the connection terminals 85 and the reinforcing layer 86.

In this regard, in the case where the curable resin component is used as the resin component contained in the resin composition layers 11 and 13, it is preferred that the curable resin composition is not completely cured in the heat step [2]. This makes it possible to re-melt the reinforcing layer 86 by being heated when the semiconductor chip 20 on

which the connection terminals 85 and the reinforcing layer 86 have been provided is mounted onto the surface of the interposer 30 on which the wiring pattern 40 is provided.

By placing such a semiconductor chip 20 on which the connection terminals 85 and the reinforcing layer 86 have been provided onto the surface of the interposer 30 on which the wiring pattern 40 is provided, heating the connection terminals 85 and the reinforcing layer 86 so that the connection terminals 85 are remelted, and then cooling them, it is possible to form the connection portions 81 and the sealing layer 80 between the semiconductor chip 20 and the wiring pattern 40.

In this embodiment, the curable resin component is contained in the resin composition layers 11 and 13 as the resin component and a part thereof exists in a non-cured state. Therefore, by curing the curable resin composition, the sealing layer 80 is fixed. This makes it possible to improve mechanical strengths of the connection portions 81 and the sealing layer 80.

<<Fourth embodiment>>

The fourth embodiment in which the resin composition layers 11 and 13 of the conductive connecting sheet 1 are formed of the thermoplastic resin composition include: a placement step of placing the conductive connecting sheet 1 on the surface of the semiconductor chip 20 on which the terminals 21 are provided; and a heat step of heating the conductive connecting sheet 1 at a temperature which is a melting point of the metal layer 12 or higher and at which the thermoplastic resin composition constituting the resin composition layers 11 and 13 is softened.

Hereinbelow, each of the steps will be described in detail.

[1] Placement step

Also in this embodiment in which the resin composition layers 11 and 13 are formed of the thermoplastic resin composition, the conductive connecting sheet 1 is thermally compression bonded to (placed on) the surface of the semiconductor chip 20 on which the terminals 21 are provided in the same manner as described in the third embodiment in which the resin composition layers 11 and 13 are formed of the curable resin composition. In this way, the conductive connecting sheet 1 makes contact with the terminals 21 exposed in the surface of the semiconductor chip 20 on which the terminals 21 is provided.

[2] Heat step

Next, as shown in FIG. 6(b), the conductive connecting sheet 1 (metal layer 12) placed on the surface of the semiconductor chip 20 on which the terminals 21 is provided in the placement step [1] is heated at a temperature which is a melting point of the metal layer 12 or higher.

A temperature for heating the conductive connecting sheet 1 is set to the same temperature at which the conductive connecting sheet 1 is heated in the heat step [2] of the first embodiment.

In the case where the conductive connecting sheet 1 is heated at such a temperature, the metal layer 12 is melted. As a result, the melted metal layer 12, that is, the melted metal material having low melting point comes to be able to move in the resin composition layers 11 and 13.

At this time, since the kind and the amount of the compound having flux function contained in the thermoplastic resin composition is set so that the wet extension of the metal balls 91 becomes 37% or more in the present invention, the oxide layer formed on the surface of the metal layer 12 is reliably removed by being reduced due to the reduction action of the compound having flux function. For this reason, the wettability of the melted metal material is improved so that a metal bond thereof is enhanced. Therefore, the melted metal material can be easily aggregated onto the surfaces of the terminals 21.

Further, the oxide layers formed on the surfaces of the terminals 21 are also removed by being reduced due to the reduction action of the compound having flux function, to thereby improve the wettability thereof. As a result, a metal bond thereof with respect to the metal material is also enhanced. Also for this reason, the melted metal layer 12 also can be easily aggregated onto the surfaces of the terminals 21.

Furthermore, in the present invention, since the metal layer 12 is of the layer shape (foil shape), when the melted metal layer 12 is separated into a plurality of parts and aggregated onto the surfaces of the terminals 21, it is possible to appropriately suppress or prevent a part of the melted metal layer 12 from existing within the resin composition layers 11 and 13 without being aggregated on the terminals 21. This makes it possible to reliably prevent the generation of the leak current due to the existence of a part of the metal layer 12 within the reinforcing layer 86.

For these reasons, the melted metal material moves within the resin composition layers 11 and 13, that is, the thermoplastic resin composition and is selectively aggregated onto the surfaces of the terminals 21. As a result, as shown in FIG. 6(C), the connection terminals 85 each formed of the metal material are formed on the surfaces of the

terminals 21.

At this time, by cooling the Thermoplastic resin composition, the thermoplastic resin composition is hardened so as to surround the connection terminals 85 to thereby form the reinforcing layer 86. As a result, it is possible to secure the insulating property between the adjacent connection terminals 85. This makes it possible to reliably prevent the adjacent connection terminals 85 from being shorted.

According to such a method for forming the connection terminals 85 and the reinforcing layer 86, the connection terminals 85 can be formed by selectively aggregating the heated and melted metal material onto the terminals and the reinforcing layer 86 constituted from the thermoplastic resin composition can be formed so as to surround the connection terminals 85. As a result, it is possible to secure the insulating property between the adjacent connection terminals 85.

Further, also in a semiconductor chip 20 having a plurality of terminals 21 provided at a fine pitch, the plurality of connection terminals 85 can be formed so as to correspond to the terminals 21 all at once.

In this regard, during this step [2], the conductive connecting sheet 1 and the semiconductor chip 20 may be heated in a state that they are compressed so that the conductive connecting sheet 1 and the terminals 21 are made close to each other. For example, in FIG. 6(b), by heating and compressing the conductive connecting sheet 1 and the semiconductor chip 20 using a means such as a well-known thermal compression bonding machine in a direction of making them close to each other, it is possible to constantly control a distance between the conductive connecting sheet 1 and the terminals 21. This makes it possible to improve aggregation capacity of the melted metal material onto the surfaces of the terminals 21.

Further, during the compression or the heat, ultrasound, an electric field or the like may be applied to the conductive connecting sheet 1, specific heat using laser, electromagnetic induction or the like may be used.

Through the above step [1] and the above step [2], the connection terminals 85 and the reinforcing layer 86 are formed. That is, the method for forming connection terminals according to the present invention is used in the placement step [1] and the heat step [2] for forming the connection terminals 85 and the reinforcing layer 86.

As described above, in the case where the connection terminals 85 are formed on the surface of the semiconductor chip 20 on which the terminals 21 are provided, by placing the conductive connecting sheet 1 on areas where the connection terminals 85 are to be formed, and then heating it, the melted metal layer 12 is selectively aggregated on the terminals 21 to thereby form the connection terminals 85.

By placing such a semiconductor chip 20 on which the connection terminals 85 and the reinforcing layer 86 have been provided onto the surface of the interposer 30 on which the wiring pattern 40 is provided, heating the connection terminals 85 and the reinforcing layer 86 so that the connection terminals 85 are remelted, and then cooling them, it is possible to form the connection portions 81 and the sealing layer 80 between the semiconductor chip 21 and the wiring pattern 40.

In this embodiment, the thermoplastic resin component is contained in the resin composition layers 11 and 13 as the resin component. Therefore, the thermoplastic resin composition can be hardened by being cooled as described above. In this way, the sealing layer 80 is fixed (secured), which makes it possible to improve the mechanical strengths of the connection portions 81 and the sealing layer 80.

Through the above steps, the connection terminals 85 are formed on the surface of the semiconductor chip 20 on which the terminals 21 are provided and the reinforcing layer 86 is formed so as to surround to the connection terminals 85.

In this regard, the method for forming connection terminal according to the present invention is used for forming the connection terminals 85 so as to correspond to the terminals 21 of the semiconductor chip 20, but is not limited to such an use. The present invention can be used for forming connection terminals (bumps) on terminals (electrodes) of electronic components provided in various kinds of electronic devices. Examples of the electronic components include a semiconductor wafer, a flexible substrate and the like.

While the conductive connecting sheet, the method for connecting terminals, the method for forming connection terminal, the semiconductor device and the electronic device according to the present invention have been described hereinabove, the present invention shall not be limited thereto.

For example, each structure constituting the conductive connecting sheet of the present invention is substituted for an arbitrary structure having the same function as it. Further, arbitrary structures also may be added thereto.

Further, one or more arbitrary steps may be added to the method for connecting terminals or the method for forming connection terminal according to the present invention.

## EXAMPLES

Next, description will be made on specific examples of the present invention.

1. Evaluation method

On a terminal connection body manufactured by connecting facing terminals to each other using a conductive connecting sheet obtained in each of Examples and Comparative Examples, electrical resistance between the terminals, ease of conduction pass (connection portion) formation, and presence or absence of a metal layer remaining in a sealing layer corresponding to an area other than the conduction passes were measured or evaluated according to the following methods.

(1) Electrical resistance

Resistance between the facing terminals of the manufactured terminal connection body was measured by a four-terminal method (resistance meter: "Digital Multimeter VOA7510" produced by IWATSU ELECTRIC CO., LTD., measurement probe: "9771 PIN TYPE LEAD" produced by HIOKI E. E. CORPORATION) at 12 points. A case that an average value thereof is less than 30 mΩ is evaluated as "A" and a case that an average value thereof is 30 mΩ or more is evaluated as "B".

(2) Ease of conduction pass formation

On 10 pairs of the facing terminals of the manufactured terminal connection body, each of cross sections thereof was observed suing a scanning electron microscope ("JSM-7401F" produced by JEOL Ltd.). A case that cylindrical conduction passes (connection portions) each made of a solder are formed in all 10 pairs is evaluated as "A", a case that the conduction pass is not formed in at least one pair is evaluated as "B", and a case that the conduction pass makes contact with the adjacent terminal(s) so as to be shorted is evaluated as "C".

(3) Presence or absence of remaining solder

A cross section of the manufactured terminal connection body was observed suing a scanning electron microscope (SEM) (model number "JSM-7401F" produced by JEOL Ltd.). A case that the metal layer (metal material) contributes to the formation of all the conduction passes between the facing terminals is evaluated as "A", and a case that a part of the metal layer remains in the resin (sealing layer) other than gaps between the facing terminals (conduction passes) without contributing to the formation of the conduction passes is evaluated as "B".

2. Measurement of wet extension of metal ball

At least a part of metal balls was provided within the resin composition layer of the conductive connecting sheet produced in each of Examples and Comparative Examples, and then melted by being heated. Thereafter, the wet extension of the melted metal balls was measured.

More specifically, the wet extension of the metal balls within the resin composition layer of the conductive connecting sheet produced in each of Examples and Comparative Examples was measured as follows.

First, a copper plate having a length of 1.0 cm × a width of 1.0 cm × a height of 0.3 mm was prepared, a resin composition layer having a thickness of 30 μm was formed onto the copper plate using a resin composition prepared for forming the resin composition layer of the conductive connecting sheet produced in each of Examples and Comparative Examples, and then 5 metal balls each having a diameter "D" of 0.5 mm were placed on the resin composition layer. In this way, a sheet for measuring wet extension was obtained.

Next, the metal balls placed on the resin composition layer were compression bonded using a thermal compression bonding machine ("TMV1-200ABS" produced by TSUKUBA MECHANIX) under the conditions in which a load was 50 N, a temperature was 80°C and a time was 5 seconds. In this way, a part of the metal balls was embedded into the resin composition layer.

Next, the metal balls were heated at a temperature 30°C higher than a melting point of the metal material having low melting point constituting the metal balls for 20 seconds, to thereby melt the metal balls.

Next, the melted metal balls were hardened by being cooled, and then the resin composition layer was dissolved into acetone so that it was removed from the copper plate.

Next, a height "H" [mm] of each metal ball exposed on the copper plate by removing the resin composition layer was measured, and then the wet extension of the metal balls "S" [%] was obtained using the above formula 1.

3. Measurement of acid value of resin composition layer

An acid value of the resin composition layer of the conductive connecting sheet produced in each of Examples

and Comparative Examples was measured using a potentiometric titration.

More specifically, the acid value of the resin composition layer of the conductive connecting sheet produced in each of Examples and Comparative Examples was measured as follows.

Namely, about 0.2 g of the resin composition constituting the resin composition layer was exactly weighted, and then dissolved into acetone (100 mL) to thereby prepare a resin composition solution. Thereafter, this resin composition solution was titrated with a sodium hydroxide aqueous solution (0.05 mol/L), and a titration curve was drawn using a potential automatic titrator ("AT-500N" produced by KYOTO ELECTRONICS MANUFACTURING CO., LTD., complex glass electrode: "98-100-Cl73" produced by KYOTO ELECTRONICS MANUFACTURING CO., LTD.).
And, by defining a weight of the resin composition as M [g], a concentration of the sodium hydroxide aqueous solution as C [mol/L] and an amount of the sodium hydroxide aqueous solution dropped (titrated) up to an end point, which is an inflection point on the drawn titration curve, as A [L], the acid value can be calculated using the above formula 2.

4. Production of conductive connecting sheet and sheet for measuring wet extension

[Examples 1 to 6, Comparative Examples 1 and 2]

First, prepared were bisphenol A type epoxy resin ("EPICLON-840S" produced by Dainippon Ink and Chemicals Inc., epoxy equivalent: 185 g/eq) as an epoxy resin; phenol novolac resin ("PR-53647" produced by Sumitomo Bakelite Co., Ltd.) as a curing agent; modified biphenol epoxy ("YX-6954" produced by the Japan Epoxy Resins Co., Ltd.) as a film-forming resin; sebacic acid (produced by Tokyo Kasei Kogyo Co., Ltd., Compound 1), gentisic acid (produced by Midori Kagaku Co., Ltd., Compound 2) and phenol phthalin (produced by Tokyo Kasei Kogyo Co., Ltd., Compound 3) as a compound having flux function; 2- (3,4-epoxy cyclohexyl) ethyl trimethoxy silane ("KBM-303" produced by Shin-Etsu Chemical Co., Ltd.) as a silane coupling agent; and 2-phenyl-4-methyl imidazole ("CURAZOLE 2P4MZ" produced by SHIKOKU CHEMICALS CORPORATION) as an accelerator, respectively.

Next, in each of Examples and Comparative Examples, components shown in Table 1 or 2 were mixed with each other in a ratio shown therein to obtain a resin composition for forming a resin composition layer of a conductive connecting sheet, and the resin composition was dissolved into methyl ethyl ketone (MEK). In this way, a resin composition varnish containing 40% of solid contents was prepared. The obtained varnish was applied onto a polyester sheet using a comma coater, and then died under the condition of 90°C × 5 minutes, to thereby obtain a film-like resin composition having a thickness of 30 μm.

Next, as a metal layer, prepared were a solder foil A (Sn/Pb = 63/37 (weight ratio), melting point: 183°C, density: 8.4 g/cm$^3$ thickness: 10 μm) and a solder foil B (Sn/Ag/Cu = 96.5/3.0/0.5 (weight ratio), melting point: 217°C, density: 7.4 g/cm$^3$, thickness: 10 μm).

According to each of Examples and Comparative Examples, the solder foil A or the solder foil B as the metal layer was selected as shown in Table 1 or 2, and then the film-like resin compositions prepared for each of Examples and Comparative Examples were layered to both surfaces of the metal layer under the condition of 60°C, 0.3 Mpa and 0.3 m/min. In this way, produced was a conductive connecting sheet including resin composition layers each having a thickness of 30 μm on both surfaces of the metal layer.

Further, as a metal ball, prepared were a solder ball A (Sn/Pb = 63/37 (weight ratio), melting point: 183°C, density: 8.4 g/cm$^3$, diameter: 0.5 mm) and a solder ball B (Sn/Ag/Cu = 96.5/3.0/0.5 (weight ratio), melting point: 217°C, density: 7.4 g/cm$^3$, diameter: 0.5 mm).

According to each of Examples and Comparative Examples, the solder ball A or the solder ball B as the metal ball was selected as shown in Table 1 or 2 so as to correspond to the solder foil A or the solder foil B, a resin composition layer was formed on a separately prepared copper plate using the resin composition prepared for each of Examples and Comparative Examples, and then the metal balls were placed onto the resin composition layer. In this way, produced was a sheet for measuring wet extension which was used for measuring the wet extension of the metal balls.

Thereafter, on each of the sheets for measuring wet extension, the wet extension of the metal balls was measured using the above mentioned measurement method for the wet extension of the metal balls. This result is shown in Table 1 or 2.

5. Connection between terminals using conductive connecting sheet

Next, connection between facing terminals was carried out using the conductive connecting sheet produced in each of Examples and Comparative Examples.

More specifically, prepared were two substrates each including a FR-4 base member (thickness: 0.1 mm), a circuit layer (copper circuit, thickness: 12 μm), and connection terminals (thickness: 3 μm, terminal diameter: 100 μm, center distance of adjacent terminals: 300 μm) each formed by subjecting the circuit circuit to Ni/Au plating.

Next, in each of Examples and Comparative Examples, the conductive connecting sheet prepared for each of

Examples and Comparative Examples was placed between the substrates each having the above structure, and then they were subjected to compression bonding (gap between substrates: 50 μm) using a thermal compression bonding machine ("TMV1-200ABS" produced by TSUKUBA MECHANIX) under the condition shown in Table 1 or 2. In this way, the facing terminals were electrically connected to each other by forming connection portions therebetween. Thereafter, the resin composition was cured by being heated at 180°C for 1 hour, to thereby obtain a terminal connection body.

Next, on the terminal connection body, the electrical resistance between facing terminals, the ease of conduction pass formation and the presence or absence of remaining solder within the insulating area were evaluated using the above mentioned evaluation method. This result is shown in Table 1 or 2.

6. Measurement of acid value of resin composition layer of conductive connecting sheet

The resin composition prepared for each of Examples and Comparative Examples was dried, 0.2 g thereof was weighted, and then an acid value of the weighted resin composition was measured using the above mentioned measurement of acid value of resin composition layer. This result is shown in Table 1 or 2.

[Table 1]

Table 1

| | | | Ex. 1 | Ex. 2 | Ex. 3 | Ex. 4 | Ex. 5 | Ex. 6 |
|---|---|---|---|---|---|---|---|---|
| Amount [Parts by weight] | Resin composition | Epoxy resin | 40.0 | 40.0 | 40.0 | 40.0 | 40.0 | 40.0 |
| | | Curing agent | 25.0 | 25.0 | 21.5 | 23.5 | 19.5 | 9.5 |
| | | Film-forming resin | 30.0 | 30.0 | 30.0 | 30.0 | 30.0 | 30.0 |
| | | Compound having flux function 1 | 4.5 | 4.5 | 8.0 | 2.0 | | |
| | | Compound having flux function 2 | | | | 4.0 | | |
| | | Compound having flux function 3 | | | | | 10.0 | 20.0 |
| | | Silane coupling agent | 0.5 | 0.5 | 0.5 | 0.5 | 0.5 | 0.5 |
| | | Accelerator | 0.01 | 0.01 | 0.01 | 0.01 | 0.01 | 0.01 |
| | | Total | 100.0 | 100.0 | 100.0 | 100.0 | 100.0 | 100.0 |
| | Metal foil | Solder foil A | Used | | | | Used | |
| | | Solder foil B | | Used | Used | Used | | Used |
| Physical property of curable resin composition | Solder wet extension [%] | Sn/Pb=63/37 (Melting point: 183°C) | 78 | - | - | - | 75 | - |
| | | Sn/Ag/Cu = 96.5/3.0/0.5 (Melting point: 217°C) | - | 55 | 60 | 59 | - | 56 |
| | Acid value [mol/g] | | 4.5 E-04 | 4.5 E-04 | 8.0 E-04 | 4.3 E-04 | 3.0 E-04 | 6.0 E-04 |
| Substrate connection condition | Thermal compression bonding condition | Temperature [°C] | 200 | 230 | 230 | 230 | 200 | 230 |
| | | Pressure [MPa] | 0.5 | 0.5 | 0.5 | 0.5 | 0.5 | 0.5 |
| | | Time [second] | 120 | 120 | 120 | 120 | 120 | 120 |

(continued)

| | | Ex. 1 | Ex. 2 | Ex. 3 | Ex. 4 | Ex. 5 | Ex. 6 |
|---|---|---|---|---|---|---|---|
| Evaluation result | Electrical resistance between facing terminals | A | A | A | A | A | A |
| | Ease of conduction pass formation | A | A | A | A | A | A |
| | Presence or absence or remaining solder | A | A | A | A | A | A |

Epoxy resin: bisphenol A type epoxy resin, "EPICLON-840S" produced by Dainippon Ink and Chemicals Inc., epoxy equivalent: 185 g/eq
Curing agent: phenol novolac resin, "PR-53647" produced by Sumitomo Bakelite Co., Ltd.
Film-forming resin: modified bisphenol epoxy, "YX-6954" produced by the Japan Epoxy Resins Co., Ltd.
Compound having flux function 1: sebacic acid, "sebacic acid" produced by Tokyo Kasei Kogyo Co., Ltd.
Compound having flux function 2: gentisic acid, "gentisic acid" produced by Midori Kagaku Co., Ltd.
Compound having flux function 3: phenol phthalin, "phenol phthalin" produced by Tokyo Kasei Kogyo Co., Ltd.
Silane coupling agent: 2- (3, 4-epoxy cyclohexyl) ethyl trimethoxy silane, "KBM-303" produced by Shin-Etsu Chemical Co., Ltd.
Accelerator: 2-phenyl-4-methyl imidazole ("CURAZOLE 2P4MZ" produced by SHIKOKU CHEMICALS CORPORATION)
Solder foil A: Sn/Pb = 63/37 (melting point: 183°C)
Solder foil B: Sn/Ag/Cu = 96.5/3.0/0.5 (melting point: 217°C).

[Table 2]

Table 2

| | | | Comp. Ex. 1 | Comp. Ex. 2 |
|---|---|---|---|---|
| Amount [Parts by weight] | Resin composition | Epoxy resin | 40.0 | 40.5 |
| | | Curing agent | 29.0 | 29.0 |
| | | Film-forming resin | 30.0 | 30.0 |
| | | Compound having flux function 3 | 0.5 | |
| | | Silane coupling agent | 0.5 | 0.5 |
| | | Accelerator | 0.01 | 0.01 |
| | | Total | 100.0 | 100.0 |
| | Metal foil | Solder foil B | Used | Used |
| Physical property of curable resin composition | Solder wet extension [%] | Sn/Pb = 63/37 (Melting point: 183°C) | - | - |
| | | Sn/Ag/Cu = 96.5/3.0/0.5 (Melting point: 217°C) | 15 | Unmeasurable |
| | Acid value [mol/g] | | 1.5 E-05 | Unmeasurable |
| Substrate connection condition | Thermal compression bonding condition | Temperature [°C] | 200 | 200 |
| | | Pressure [MPa] | 0.5 | 0.5 |
| | | Time [second] | 120 | 120 |

(continued)

| | | Comp. Ex. 1 | Comp. Ex. 2 |
|---|---|---|---|
| Evaluation result | Electrical resistance between facing terminals | B | B |
| | Ease of conduction pass formation | B | B |
| | Presence or absence of remaining solder | B | B |

Epoxy resin: bisphenol A type epoxy resin, "EPICLON-840S" produced by Dainippon Ink and Chemicals Inc., epoxy equivalent: 185 g/eq
Curing agent: phenol novolac resin, "PR-53647" produced by Sumitomo Bakelite Co., Ltd.
Film-forming resin: modified biphenol epoxy, "YX-6954" produced by the Japan Epoxy Resins Co., Ltd.
Compound having flux function 3: phenol phthalin, "phenol phthalin" produced by Tokyo Kasei Kogyo Co., Ltd.
Silane coupling agent: 2-(3,4-epoxy cyclohexyl) ethyl trimethoxy silane, "KBM-303" produced by Shin-Etsu Chemical Co., Ltd.
Accelerator: 2-phenyl-4-methyl imidazole ("CURAZOLE 2P4MZ" produced by SHIKOKU CHEMICALS CORPORATION)
Solder foil B: Sn/Ag/Cu = 96.5/3.0/0.5 (melting point: 217°C).

As shown in Table 1 or 2, in each of Examples, the acid value of the resin composition falls within a range of $3.0\times10^{-5}$ to $1.0\times10^{-2}$ mol/g. This makes it possible to set the wet extension of the metal balls to 37% or more.
Further, by setting the wet extension of the metal balls to a value within such a range, it appears that, in each of Examples, the metal layer can be selectively aggregated between the terminals and a good result in each evaluation can be obtained.
On the other hand, in each of Comparative Examples, since the acid value of the resin composition layer, an oxide layer formed on a surface of the metal layer can be sufficiently removed so that the wet extension of the metal balls is less than 37%. For this reason, the metal layer cannot be selectively aggregated between the terminals and a result in each evaluation is obviously inferior to that of each of Examples.

## INDUSTRIAL APPLICABILITY

In the case where the conductive connecting sheet of the present invention is used for forming connection portions electrically connecting terminals to each other, the connection portions can be formed by selectively aggregating a heated and melted metal material between the terminals and a sealing layer constituted from a resin component can be formed so as to surround the connection portions.
As a result, since peripheries of the connection portions can be covered by the resin component, the connection portions are fixed. Further, since an insulating property between the adjacent terminals can be secured by the sealing layer, generation of a leak current between the adjacent terminals can be reliably prevented.
Further, in the case where the conductive connecting sheet is used for forming connection terminals to be provided so as to correspond to electrodes, the connection terminals can be formed by selectively aggregating a heated and melted metal material onto the electrodes and a reinforcing layer constituted from a resin component can be formed so as to surround the connection terminals.
As a result, since peripheries of connection terminals can be covered by the resin component, the connection terminals are fixed. Further, since an insulating property between the adjacent connection terminals is secured by the reinforcing layer, generation of a leak current between the adjacent connection terminals can be reliably prevented.
Therefore, the present invention provides industrial applicability.

## Claims

**1.** A conductive connecting sheet composed of a layered body, the layered body comprising:

at least one resin composition layer formed of a resin composition containing a resin component and a compound having flux function; and
a metal layer formed of a metal material having low melting point,
wherein the resin composition layer satisfies the following requirement A:

in the case where at least a part of metal ball(s) made of the metal material having low melting point is

provided within the resin composition layer, the metal ball(s) is heated at a temperature which is a melting temperature thereof or higher according to "test methods for soldering resin type fluxes" defined in JIS Z 3197, and then a wet extension of the metal ball(s) is measured, the wet extension is 37% or more.

**2.** The conductive connecting sheet as claimed in claim 1, wherein in the case where a diameter of the metal ball before being heated is defined as "D" [mm] and a height of the metal ball after being heated is defined as "H" [mm], the wet extension "S" [%] is obtained based on the following formula 1:

$$S\ [\%] = (D-H)/D \times 100 \cdots \text{formula 1.}$$

**3.** The conductive connecting sheet as claimed in claim 1, wherein the metal ball is formed of a metal alloy containing at least two metals selected from the group consisting of tin (Sn), lead (Pb), silver (Ag), bismuth (Bi), indium (In), zinc (Zn), nickel (Ni), antimony (Sb), iron (Fe), aluminum (Al), gold (Au), germanium (Ge) and copper (Cu), or tin alone.

**4.** The conductive connecting sheet as claimed in claim 3, wherein the metal ball is formed of a Sn-Pb metal alloy, a Sn-Ag-Cu metal alloy or a Sn-Ag metal alloy as a major component thereof.

**5.** The conductive connecting sheet as claimed in claim 4, wherein the Sn-Pb metal alloy contains a Sn-37Pb metal alloy and the Sn-Ag-Cu metal alloy contains a Sn-3.0Ag-0.5Cu metal alloy.

**6.** The conductive connecting sheet as claimed in claim 1, wherein a diameter of the metal ball before being heated is 0.5 mm.

**7.** The conductive connecting sheet as claimed in claim 1, wherein an acid value of the resin composition is in the range of $3.0\times10^{-5}$ to $1.0\times10^{-2}$ mol/g.

**8.** The conductive connecting sheet as claimed in claim 7, wherein the acid value is calculated using an oxidation reduction titration method.

**9.** The conductive connecting sheet as claimed in claim 1, wherein an amount of the compound having flux function contained in the resin composition is in the range of 1 to 50 wt%.

**10.** The conductive connecting sheet as claimed in claim 1, wherein the compound having flux function contains a compound having at least one of a phenolic hydroxyl group and a carboxyl group.

**11.** The conductive connecting sheet as claimed in claim 10, wherein the compound having flux function contains a compound represented by the following general formula (1):

$$HOOC-(CH_2)_n-COOH \qquad (1)$$

where "n" is an integer number of 1 to 20.

**12.** The conductive connecting sheet as claimed in claim 10. wherein the compound having flux function contains at least one of a compound represented by the following general formula (2) and a compound represented by the following general formula (3):

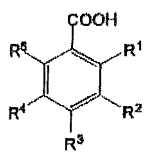

(2)

where each of $R^1$ to $R^5$ is independently an univalent organic group, and at least one of $R^1$ to $R^5$ is a hydroxyl group; and

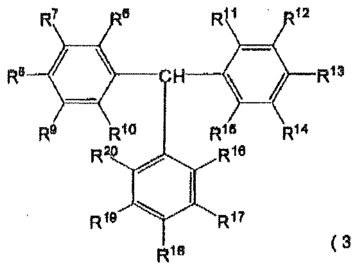

(3)

where each of $R^6$ to $R^{20}$ is independently an univalent organic group, and at least one of $R^6$ to $R^{20}$ is a carboxyl group.

**13.** The conductive connecting sheet as claimed in claim 1, wherein the at least one resin composition layer comprises two resin composition layers, and
wherein in the layered body, one of the resin composition layers, the metal layer and the other resin composition layer are layered together in this order.

**14.** A method for connecting terminals comprising:

a placement step of placing the conductive connecting sheet defined by claim 1 between facing terminals;
a heat step of heating the conductive connecting sheet at a temperature which is a melting point of the metal material or higher and at which curing of the resin composition is not finished; and
a curing step of curing the resin composition.

**15.** A method for connecting terminals comprising:

a placement step of placing the conductive connecting sheet defined by claim 1 between facing terminals;
a heat step of heating the conductive connecting sheet at a temperature which is a melting point of the metal material or higher and at which the resin composition is softened; and
a hardening step of hardening the resin composition.

**16.** A method for forming connection terminal comprising:

a placement step of placing the conductive connecting sheet defined by claim 1 onto a terminal of an electronic member; and
a heat step of heating the conductive connecting sheet at a temperature which is a melting point of the metal material or higher and at which curing of the resin composition is not finished.

**17.** A method for forming connection terminal comprising:

a placement step of placing the conductive connecting sheet defined by claim 1 onto a terminal of an electronic member; and
a heat step of heating the conductive connecting sheet at a temperature which is a melting point of the metal material or higher and at which the resin composition is softened.

**18.** A semiconductor device comprising:

facing terminals; and
a connection portion electrically connecting the facing terminals and being formed using the conductive connecting sheet defined by claim 1.

**19.** An electronic device comprising:

facing terminals; and
a connection portion electrically connecting the facing terminals and being formed using the conductive connecting sheet defined by claim 1.

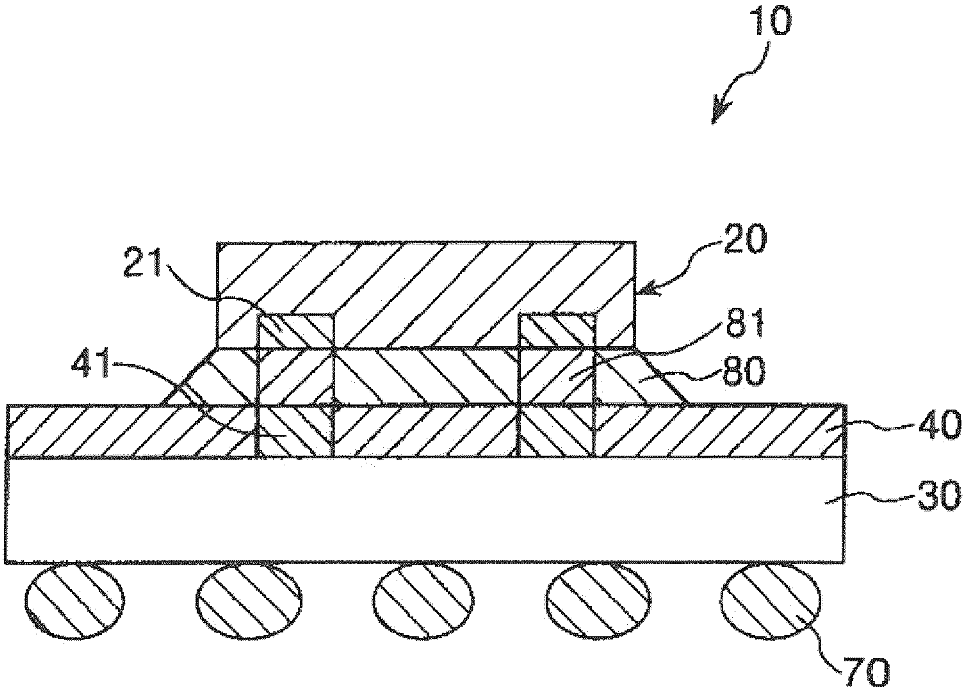


FIG. 1

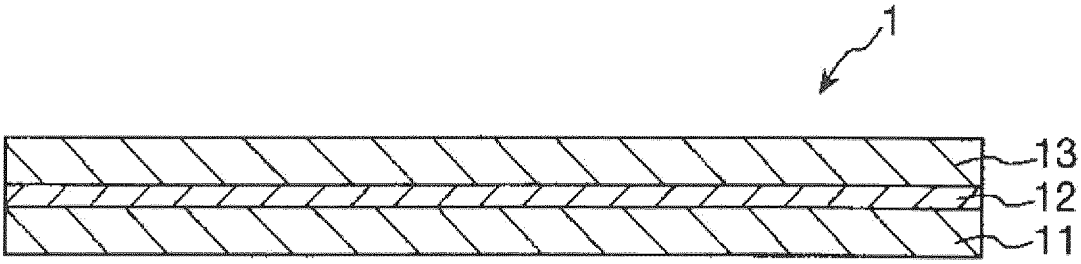


FIG. 2

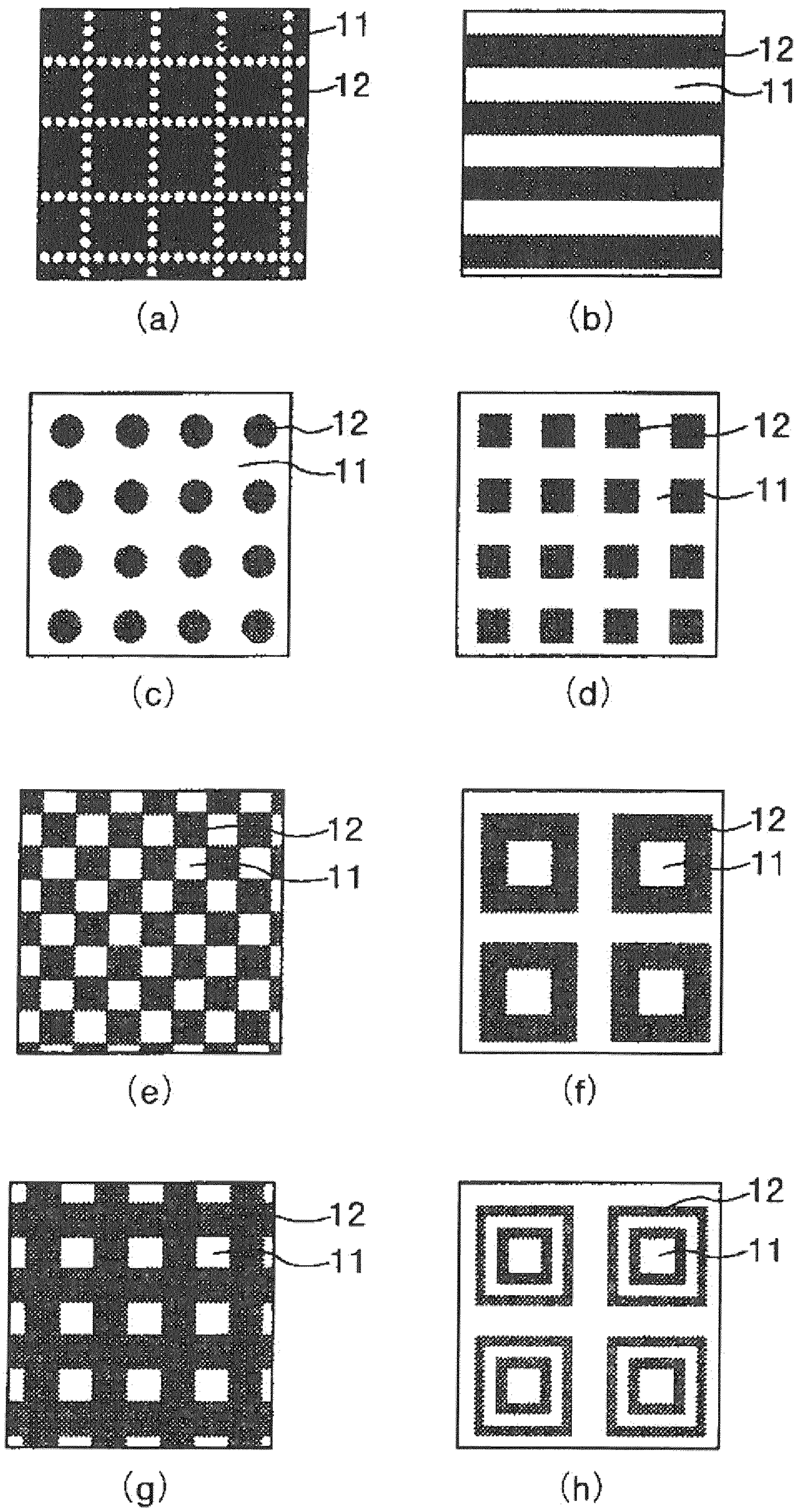


FIG. 3

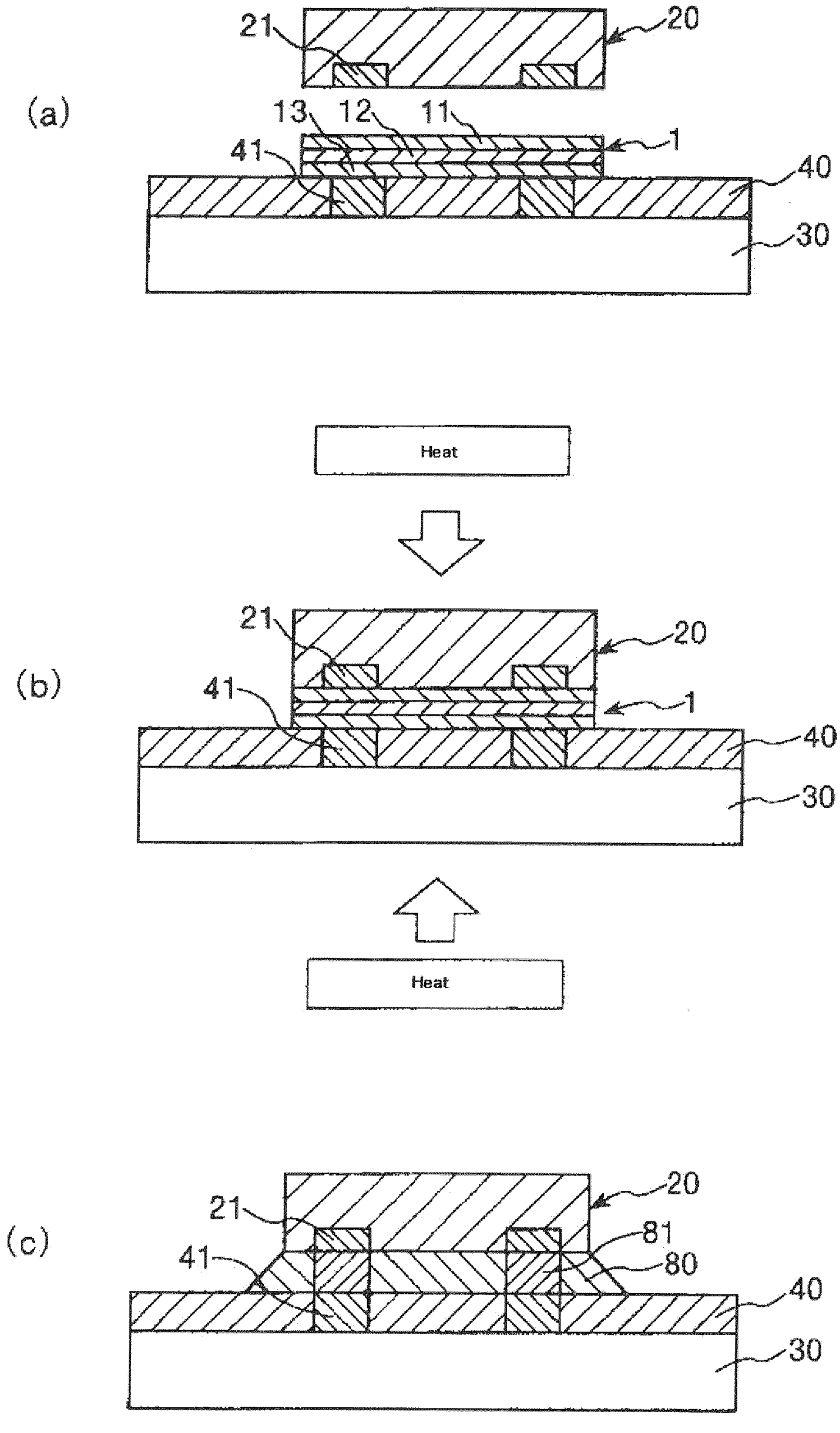
(a)
21
20
13
12
11
1
41
40
30
Heat
(b)
21
20
41
1
40
30
Heat
(c)
21
20
81
41
80
40
30

FIG. 4

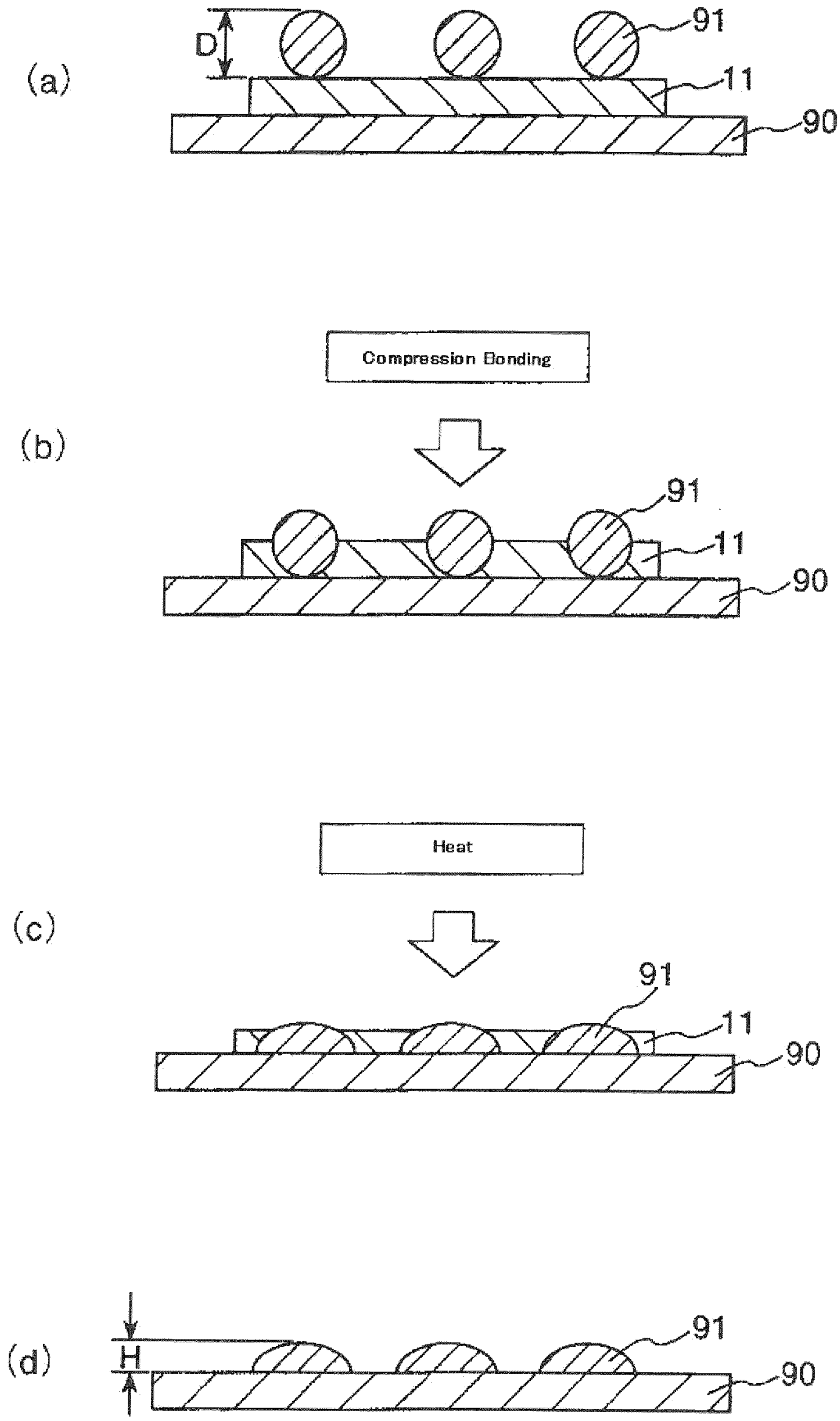
(a)
D
91
11
90
Compression Bonding
(b)
91
11
90
Heat
(c)
91
11
90
(d)
H
91
90

FIG. 5

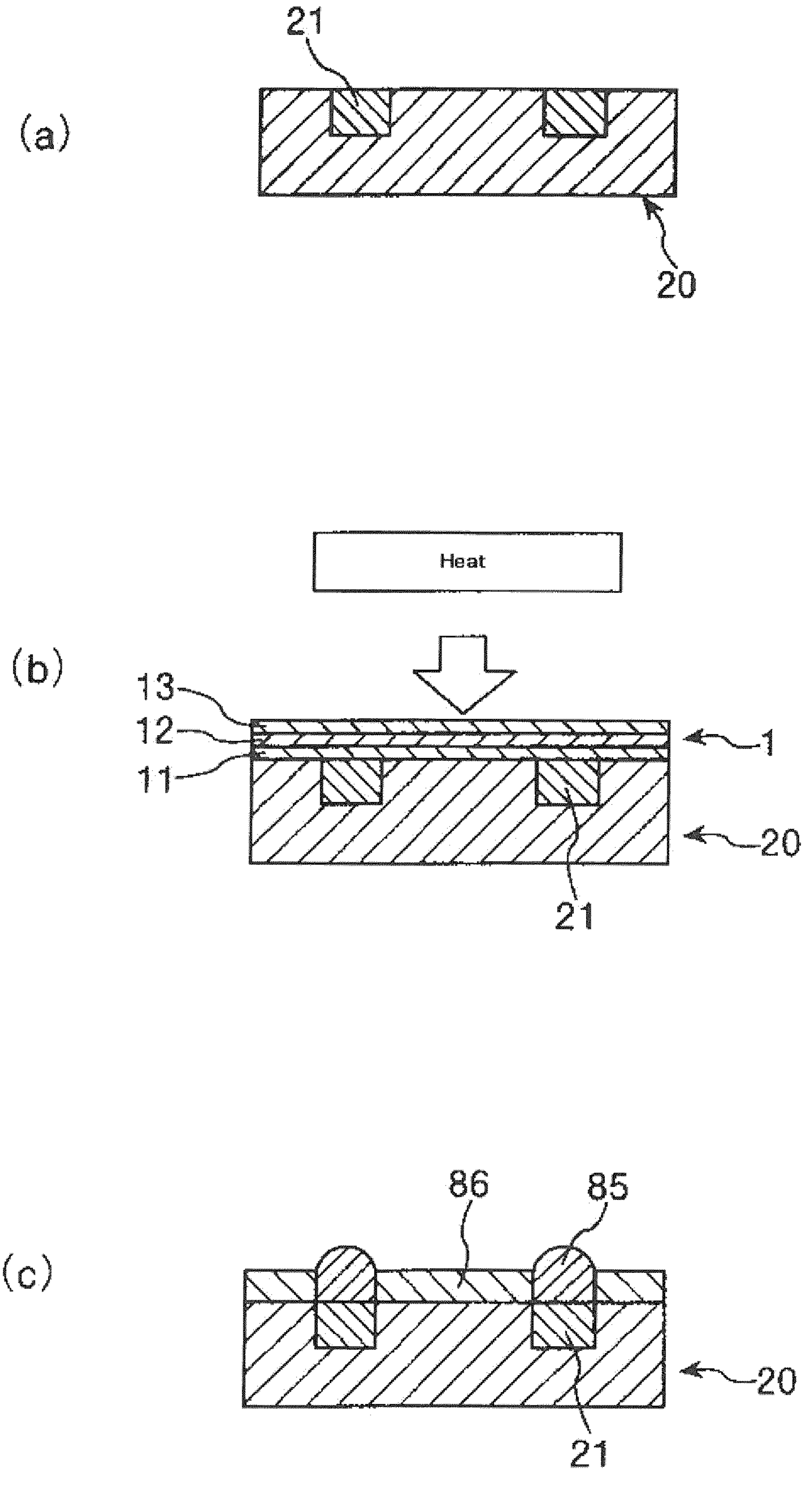


FIG. 6

**INTERNATIONAL SEARCH REPORT**

International application No.
PCT/JP2011/050684

A. CLASSIFICATION OF SUBJECT MATTER
*H01R11/01*(2006.01)i, *C09D7/12*(2006.01)i, *C09D201/00*(2006.01)i, *H01B1/22*(2006.01)i, *H01B5/16*(2006.01)i, *H01L21/60*(2006.01)i, *H01R4/02*(2006.01)i, *H01R43/02*(2006.01)i, *H05K3/32*(2006.01)i
According to International Patent Classification (IPC) or to both national classification and IPC

B. FIELDS SEARCHED
Minimum documentation searched (classification system followed by classification symbols)
H01R11/01, C09D7/12, C09D201/00, H01B1/22, H01B5/16, H01L21/60, H01R4/02, H01R43/02, H05K3/32

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br><br>A | JP 2009-262227 A (Hitachi Chemical Co., Ltd.), 12 November 2009 (12.11.2009), paragraphs [0021] to [0099]; fig. 1 to 3 & WO 2009/123285 A1 | 1-6,9,10, 13-19<br>7,8,11,12 |
| Y | JP 2004-114104 A (Omae Seiko Yugen Kaisha), 15 April 2004 (15.04.2004), paragraphs [0012] to [0024]; fig. 1 to 5 & KR 10-2003-0028803 A | 1-6,9,10, 13-19 |
| Y | JP 2004-244486 A (Sumitomo Bakelite Co., Ltd.), 02 September 2004 (02.09.2004), paragraphs [0011] to [0069]; fig. 1 to 4 (Family: none) | 9 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 February, 2011 (07.02.11) | 15 February, 2011 (15.02.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP S61276873 A
- JP 2004260131 A